# EUROPEAN PATENT SPECIFICATION

(11) **EP 3 783 435 B1**
(45) Date of publication and mention of the grant of the patent: **09.02.2022**
(21) Application number: 19826576.1
(22) Date of filing: 20.06.2019
(51) Int. Cl.: B41C 1/10, B41M 1/06, B41N 1/00

(54) **LITHOGRAPHIC PRINTING ORIGINAL PLATE, METHOD FOR MANUFACTURING LITHOGRAPHIC PRINTING PLATE, AND METHOD FOR MANUFACTURING PRINTS USING SAME**
LITHOGRAPHISCHE DRUCKORIGINALPLATTE, VERFAHREN ZUR HERSTELLUNG EINER LITHOGRAPHISCHEN DRUCKPLATTE UND VERFAHREN ZUR HERSTELLUNG VON DRUCKEN DAMIT
PLAQUE ORIGINALE D'IMPRESSION LITHOGRAPHIQUE, PROCÉDÉ DE PRODUCTION DE PLAQUE D'IMPRESSION LITHOGRAPHIQUE ET PROCÉDÉ DE PRODUCTION D'IMPRIMÉS L'UTILISANT

(30) Priority: 27.06.2018 JP 2018121591
(43) Date of publication of application: 24.02.2021
(73) Proprietor: Toray Industries, Inc., Tokyo, 103-8666 (JP)
(72) Inventor: TSUTSUMI, Yusuke, Otsu-shi, Shiga 520-8558 (JP); KUSE, Yasunori, Otsu-shi, Shiga 520-8558 (JP); INOUE, Takejiro, Otsu-shi, Shiga 520-8558 (JP)
(74) Representative: Prüfer & Partner mbB Patentanwälte · Rechtsanwälte
(86) International application number: PCT/JP2019/024545
(87) International publication number: WO 2020/004227

(56) References cited:
- EP-A1- 0 897 795
- EP-A1- 1 036 654
- EP-A1- 3 170 663
- WO-A1-98/31550
- WO-A1-2016/143598
- JP-A- H08 281 901
- JP-A- S60 188 947
- JP-A- 2001 324 799
- JP-A- 2011 516 919
- US-A- 6 083 664

## Description

### TECHNICAL FIELD

The present invention relates to a lithographic printing plate precursor, a method for producing a lithographic printing plate, and a method for producing printed matter using such lithographic printing plate.

### BACKGROUND ART

In recent years, there have been increasing demands for high-resolution printing plates and for chemical-free developing techniques that do not use chemical solutions as developing liquids for developing them. Accordingly, there are demands also for lithographic printing plates, which are used for lithographic printing, that can be developed in high resolution by both a chemical solution developing technique and a chemical-free developing technique. Currently, light exposure of waterless lithographic printing plates is performed mainly by the laser-induced photothermal conversion technique that causes a thermal reaction to break the heat-sensitive layer, thereby forming an image. To improve such lithographic printing plates so that they can produce high-resolution images not only by a chemical developing technique but also by a chemical-free developing technique which is low in development capability, it is essential to create heat-sensitive layers with increased sensitivity to laser beams.

To solve this problem, Patent document 1 proposes the incorporation of air bubbles in the heat-sensitive layer of a direct imageable waterless printing plate precursor in order to decrease the thermal conductivity of the heat-sensitive layer so that the diffusion of heat generated by exposure to a laser beam is suppressed, thereby promoting the chemical reaction that occurs in the laser-irradiated portion of the surface of the heat-sensitive layer. To realize a high resolution, this technique is intended to achieve an improved sensitivity by largely decreasing the adhesion between the heat-sensitive layer and the silicone layer in the laser irradiated portion (see Patent document 1).

Patent document 2 proposes the incorporation of a metal-containing organic substance serving as a heat-decomposable compound in the heat-sensitive layer of a direct imageable waterless printing plate precursor so that decomposition gas is generated in the laser irradiated portion. To realize a high resolution, this technique is intended to achieve an improved sensitivity by decreasing the adhesion between the silicone rubber layer and the heat-sensitive layer in the image area so that it can be removed easily (see Patent document 2).

Patent document 3 describes a directly imageable waterless planographic printing plate precursor having at least an ink-accepting layer and a silicone rubber layer laminated in this order on a substrate. When the printing plate precursor is assessed by thermogravimetry-gas chromatography/mass spectroscopy (TG-GC/MS) in a helium current at a heating rate of 10 °C/min, a decomposition product is generated in a temperature range of 100 °C to 200 °C in an amount of 0.001 g/m² to 1 g/m² per plate area.

Patent document 4 describes a directly imageable waterless planographic printing plate precursor that is a laminate of at least a heat-sensitive layer and a silicone rubber layer on a substrate. The heat sensitive layer includes (A) a light-to-heat converting material and (B) a compound which contains N-N bonds.

Patent document 5 describes a method for producing a planographic printing plate comprising the steps of:
- producing an original planographic printing plate which comprises a substrate, a first layer converting laser light to heat and enabling peeling and an ink-repellent layer having an ink-repellent surface in that order on said substrate,
- exposing the original planographic printing plate by laser light; and
- rubbing the surface of said original planographic printing plate, which is the surface of said ink-repellent layer, with a rubbing member in the presence of an aqueous solution containing a nonionic surfactant to physically remove laser-exposed portions of said ink-repellent layer, thereby forming the planographic plate.

Patent document 6 describes a recording material having a plate- or sheet-like substrate, at least one IR-absorbing layer, and a top layer comprising a cured silicone rubber. The IR-absorbing layer comprises at least one IR-absorbing component and at least one polymeric organic binder and decomposes under the action of IR laser radiation or changes so that its adhesion to the silicone top layer decreases.

Patent document 7 describes negative-working, IR-sensitive dry printing plates with an oleophobic topmost layer, a nitrocellulose-based imaging layer ablatable by laser discharge, and a grained metal substrate with no heat-insulating layer intervening between the imaging layer and the substrate.

Patent document 8 describes a lithographic printing form plate, wherein a heat-sensitively broken layer contains a pyrolytic compound dyed with dyestuffs. Herein, a heat-sensitively broken layer is a layer that is partially or totally decomposed by heat. A dye is used as a compound to efficiently convert laser light to heat. Preferably, a dye that has the maximum absorption wavelength in the range of 400 to 1200nm is used. A pyrolytic compound such as nitrocellulose or the like is dyed with these dyes. Molecules of the dyes generate heat when absorbing infrared rays or near infrared rays, and the heat brings about a thermal decomposition in the adjacent pyrolytic compound efficiently.

### PRIOR ART DOCUMENTS

### PATENT DOCUMENTS

[Patent document 1] Japanese Unexamined Patent Publication (Kokai) No. 2005-300586
[Patent document 2] Japanese Unexamined Patent Publication (Kokai) No. 2001-324799
[Patent document 3] EP 1 036 654 A1
[Patent document 4] EP 0 897 795 A1
[Patent document 5] US 6,083,664 A
[Patent document 6] WO 98/31550 A1
[Patent document 7] EP 3 170 663 A1
[Patent document 8] JP H08 281901 A

### SUMMARY OF THE INVENTION

### PROBLEMS TO BE SOLVED BY THE INVENTION

However, the method described in Patent document 1 that adopts the incorporation of air bubbles in the heat-sensitive layer cannot achieve a sufficiently high sensitivity in the heat-sensitive layer, and it was found that a practical high resolution cannot be attained when developing the layer by a chemical-free developing technique. When developing it with a chemical solution, furthermore, there is a fear that the solvent resistance will decrease as the crosslinking reaction of the heat-sensitive layer is inhibited by air bubbles.

The method described in Patent document 2 that adopts the incorporation of a metal-containing organic substance serving as a heat-decomposable compound in the heat-sensitive layer also fails to serve sufficiently to achieve a high sensitivity in the heat-sensitive layer, and it was found that the heat-sensitive layer was peeled off when the film thickness of the heat-sensitive layer was greatly increased in order to increase the gas generation with the aim of enhancing the sensitivity.

In such circumstances, there is a call for a printing plate precursor that is sensitive enough to produce a high-resolution image even when developed by a chemical-free technique. Thus, the main object of the present invention is to provide a high-resolution lithographic printing plate precursor.

### MEANS OF SOLVING THE PROBLEMS

The present invention provides a lithographic printing plate precursor according to claim 1, a method for producing a lithographic printing plate according to claim 12, and a method for producing printed matter according to claim 13.

### EFFECT OF THE INVENTION

Thus, the main object of the present invention is to provide a lithographic printing plate precursor that can achieve a high resolution even when developed by a chemical-free developing technique.

### DESCRIPTION OF PREFERRED EMBODIMENTS

The lithographic printing plate precursor according to the present invention is described in detail below.

The lithographic printing plate precursor according to the present invention includes at least a substrate, a heat-sensitive layer, and an ink repellent layer and is characterized in that when the lithographic printing plate precursor is placed in a heating furnace set to a temperature of 450°C and an N₂ flow rate of 100 mL/min while collecting the generated gas components in an adsorption pipe for 5 minutes, the amount of gas release from the adsorption pipe used for gas collection is 6.5 × 10⁵ g/m³ to 12.5 × 10⁵ g/m³ per m³ of the heat-sensitive layer. Here, the gas generation rate defined for the present invention is the amount (g/m³) of gas generated per m³ of the heat-sensitive layer of the lithographic printing plate precursor. The heat-sensitive layer is a layer that absorbs a laser beam and generates heat, and its thickness can be measured by cross-sectional scanning electron microscopy. It is noted that the heating furnace set to a temperature of 450°C and an N₂ flow rate of 100 mL/min simulates a rapidly heated, high temperature state such as in a laser-irradiated region of a lithographic printing plate precursor. The generated gas mainly consists of components derived from substances contained in the heat-sensitive layer and those derived from substances contained in the ink repellent layer, but for the present invention, the term "gas components" refers to the components derived from substances contained in the heat-sensitive layer. Specifically, the heat-sensitive layer include at least a polymer, and may optionally include a crosslinking agent, a near-infrared absorbing compound, and an easily heat-decomposable compound, as well as an additive other than the silicone-based surfactants and fluorine-based surfactants described later. The gas components derived from substances contained in the heat-sensitive layer include decomposition products of the polymer and may also include decomposition products of a crosslinking agent, decomposition products of a near-infrared absorbing compound, decomposition products of an easily heat-decomposable compound, and decomposition products of an additive other than the silicone-based surfactants and fluorine-based surfactants described later. For the present invention, furthermore, the amount of gas generation means the total gas generation from these components, and determined by measuring the gas generation of each component derived from the substances contained in the heat-sensitive layer of a sampled lithographic printing plate precursor, followed by calculating their total. A method for measuring the amount of gas generation will be described in detail in the section of Examples.

If the rate of gas generation per m³ of the heat-sensitive layer is less than 6.5 × 10⁵ g/m³, it may suggest that structural destruction has not occurred to a sufficient degree inside the lithographic printing plate precursor, leading to an insufficient resolution. From the viewpoint of providing a high-resolution lithographic printing plate precursor, the rate of gas generation is preferably 7.0 × 10⁵ g/m³ or more, more preferably 8.0 × 10⁵ g/m³ or more, still more preferably 9.0 × 10⁵ g/m³ or more, and still more preferably 10.0 × 10⁵ g/m³. If the rate of gas generation is more than 12.5 × 10⁵ g/m³, it is not preferred because the heat-sensitive layer will suffer excessive structural breakage and it will be impossible to ensure a sufficient solvent resistance and a sufficient peeling resistance of the heat-sensitive layer. From the viewpoint of obtaining a lithographic printing plate precursor ensuring a sufficient solvent resistance and a sufficient peeling resistance of the heat-sensitive layer, it is preferably 12.2 × 10⁵ g/m³ or less, and more preferably 12.0 × 10⁵ g/m³ or less.

The lithographic printing plate precursor according to the present invention has a substrate. In addition, it also has at least a heat-sensitive layer and an ink repelling layer on or above the substrate. Either of the heat-sensitive layer and ink repellent layer may be located nearer to the substrate, but it is preferable that the substrate, the heat-sensitive layer, and the ink repellent layer are disposed in this order.

Examples of substrates that can be used for the present invention include ordinary paper, metal, glass, film, and other materials that are generally used as substrates of conventional printing plates and suffer little dimensional change in printing processes. Specific examples thereof include paper, paper laminated with a plastic material (such as polyethylene, polypropylene, and polystyrene), plates of metals such as aluminum (and aluminum alloys), zinc, and copper, plates of glass such as soda lime and quartz, films of plastics such as silicon wafers, cellulose acetate, polyethylene terephthalate, polyethylene, polyester, polyamide, polyimide, polystyrene, polypropylene, polycarbonate, and polyvinyl acetal, and paper and plastic films having metals as listed above laminated or vapor-deposited thereon. These plastic films may be either transparent or opaque. From the viewpoint of plate inspection property, the use of an opaque film is preferred.

Of these substrates, aluminum plates are particularly preferred because they suffer less dimensional changes in the printing process and are inexpensive. Polyethylene terephthalate film is particularly preferred as a flexible substrate for quick printing. There are no specific limitations on the thickness of the substrate, and an appropriately designed thickness may be adopted to suit the printing press to be used for lithographic printing.

The lithographic printing plate precursor according to the present invention may have an organic layer on the surface of the heat-sensitive layer opposite to the surface having the ink repellent layer. Specifically, in the case where a substrate, heat-sensitive layer, and ink repulsive layer are to be stacked in this order, an organic layer may be added between the substrate and the heat-sensitive layer. The organic layer added to the lithographic printing plate precursor according to the present invention serves to impart flexibility to the lithographic printing plate precursor to maintain strong adhesion to the substrate or the heat-sensitive layer. For example, an organic layer containing a metal chelate compound as disclosed in Japanese Unexamined Patent Publication (Kokai) No. 2004-199016 or Japanese Unexamined Patent Publication (Kokai) No. 2004-334025 can be used suitably although the invention is not limited thereto.

For the present invention, the organic layer may contain a flexibility imparting agent such as polyurethane resin, natural rubber, or synthetic rubber for the purpose of imparting flexibility and controlling scratch resistance. Of these flexibility imparting agents, polyurethane resin is particularly preferred from the viewpoint of coating performance and coating liquid stability.

The organic layer may contain an active hydrogen group-containing compound for the purpose of imparting adhesiveness to the substrate or the heat-sensitive layer. Examples of the active hydrogen group-containing compound include hydroxyl group-containing compounds, amino group-containing compounds, carboxyl group-containing compounds, and thiol group-containing compounds, of which hydroxyl group-containing compounds are preferred and epoxy resin is particularly preferred from the viewpoint of adhesion to the substrate.

For the present invention, it is preferable for the organic layer to contain a pigment. The incorporation of a pigment allows the organic layer to have a light transmittance of 15% or less at any wavelength in the range of 400 to 650 nm, thereby enabling plate inspection by machine reading. Preferred pigments include inorganic white pigments such as titanium oxide, zinc oxide, and lithopone, and inorganic yellow pigments such as yellow lead, cadmium yellow, yellow iron oxide, ocher, and titan yellow. Of these pigments, titan oxide is particularly preferred from the viewpoint of concealing power and coloring power.

Described next are sensitive layers suitably used for the present invention.

For a heat-sensitive layer to be used, it is preferable that at least the surface of the heat-sensitive layer is decomposed when irradiated with a laser beam used for writing so that it decreases in the adhesive strength with the ink repulsive layer or increases in the solubility in the developing liquid. In particular, it preferably contains both a near-infrared absorbing compound having the function of absorbing a laser beam and converting it into heat (photothermal conversion) and an easily heat-decomposable compound that is easily decomposed by heat because it is considered that the near-infrared absorbing compound generates heat that acts to cause not only its own decomposition but also the decomposition of the easily heat-decomposable compound that receives the thermal energy to release gas that accelerates the decomposition of other substances.

Such a heat-sensitive layer should contain at least (1) a polymer having active hydrogen, preferably contain (1) a polymer having active hydrogen and (2) a near-infrared absorbing compound, and more preferably contain (1) a polymer having active hydrogen, (2) a near-infrared absorbing compound, and (3) a crosslinking agent, or contain (1) a polymer having active hydrogen, (2) a near-infrared absorbing compound, and (4) an easily heat-decomposable compound, and still more preferably contain (1) a polymer having active hydrogen, (2) a near-infrared absorbing compound, (3) a crosslinking agent, and (4) an easily heat-decomposable compound. Hereinafter, for the present invention, a composition used for producing a heat-sensitive layer as described above is referred to as a "heat-sensitive layer composition".

For the present invention, a heat-sensitive layer means the layer that is left after applying and then drying (removing the volatile components from) a solution or dispersion containing a heat-sensitive layer composition. Such drying may be performed either at normal temperature or at an elevated temperature.

For the present invention, the "(1) polymer having active hydrogen" that can be used suitably in the heat-sensitive layer may be a polymer having a structural unit containing active hydrogen. Examples of such a structural unit containing active hydrogen include - OH, -SH, -NH₂, -NH-, -CO-NH₂, -CO-NH-, -OC(=O)-NH-, -NH-CO-NH-, -CO-OH, -CS-OH, -CO-SH, -CS-SH, -SO₃H, -PO₃H₂, -SO₂-NH₂, -SO₂-NH-, and -CO-CH₂-CO-.

Examples of the "(1) polymer having active hydrogen" include the following: a homopolymer or a copolymer of a monomer containing a carboxyl group such as (meth)acrylic acid; a homopolymer or a copolymer of a (meth)acrylic ester containing a hydroxyl group such as hydroxyethyl (meth)acrylate and 2-hydroxypropyl (meth)acrylate; a homopolymer or a copolymer of N-alkyl (meth)acrylamide or (meth)acrylamide; a homopolymer or a copolymer of a reaction product of an amine and a glycidyl (meth)acrylate or an allyl glycidyl; a homopolymer or a copolymer of an ethylenically unsaturated monomer containing active hydrogen such as a homopolymer or a copolymer of p-hydroxystyrene or vinyl alcohol (the monomer component of the copolymer may be another ethylenically unsaturated monomer containing active hydrogen or an ethylenically unsaturated monomer containing no active hydrogen).

Furthermore, the polymer having a structural unit containing active hydrogen may also be a polymer having a structural unit containing active hydrogen in the backbone chain. Examples of such polymers include polyurethanes, polyureas, polyamides, epoxy resins, polyalkylene imines, melamine resins, novolac resins, resol resins, and cellulose derivatives. Two or more of these may be contained together.

Of them, from the viewpoint of strong adhesion to an ink repulsive layer, a polymer having an alcoholic hydroxyl group, a phenolic hydroxyl group, or a carboxyl group is preferred, of which a polymer having a phenolic hydroxyl group (a homopolymer or a copolymer of p-hydroxystyrene, a novolac resin, a resol resin, etc.) is more preferred and a novolac resin is still more preferred. Examples of the novolac resin include phenol novolac resin and cresol novolac resin.

The "(1) polymer having active hydrogen" preferably accounts for 20% by mass or more, more preferably 40% by mass or more, of the heat-sensitive layer, from the viewpoint of generating a sufficient amount of gas and in addition allowing the heat-sensitive layer to maintain a higher solvent resistance and a higher peeling resistance. It also preferably accounts for 80% by mass or less, more preferably 70% by mass or less, from the viewpoint of allowing the heat-sensitive layer to have a sufficiently high stiffness.

In addition to the polymer having active hydrogen, a polymer having no active hydrogen and having film forming property (hereinafter referred to as other polymers X) may also be contained. Examples of such other polymers X include a homopolymer or a copolymer of a (meth)acrylic ester such as polymethyl (meth)acrylate and polybutyl (meth)acrylate, a homopolymer or a copolymer of a styrene-based monomer such as polystyrene and α-methylstyrene, various synthetic rubbers such as isoprene and styrene-butadiene, a homopolymer of a vinyl ester such as polyvinyl acetate, a copolymer such as vinyl acetate-vinyl chloride, and various other condensation polymers such as polyester and polycarbonate.

It is preferable that such other polymers X altogether account for 3.5% by mass or more, more preferably 7.5% by mass or more, of the heat-sensitive layer in order to provide a heat-sensitive layer composition that can form a solution having increased coatability. In order to provide a lithographic printing plate precursor having a high resolution, they preferably account for 40% by mass or less, more preferably 20% by mass or less, of the total solid content of the heat-sensitive layer.

For the present invention, the "(2) near-infrared absorbing compound" that can be used suitably in the heat-sensitive layer is preferably one that can absorb a laser beam and converts the light energy into kinetic energy of atoms and molecules so that heat of 200°C or more is generated instantaneously at the surface of the heat-sensitive layer to cause thermal degradation of at least the surface of the heat-sensitive layer. Examples thereof include black pigments such as carbon black, carbon graphite, aniline black, and cyanine black; green pigments such as phthalocyanine based and naphthalocyanine based ones; crystal water-containing inorganic compounds; powdery metals such as iron, copper, chromium, bismuth, magnesium, aluminum, titanium, zirconium, cobalt, vanadium, manganese, and tungsten; sulfides, hydroxides, silicates, sulfates, and phosphates of these metals; and complexes of diamine compounds, dithiol compounds, phenol thiol compounds, and mercaptophenol compounds.

Furthermore, the "(2) near-infrared absorbing compound" preferably has a maximum absorption wavelength (λₘₐₓ) in the wavelength range of 700 to 1,200 nm. It is expected that a near-infrared absorbing compound having a maximum absorption wavelength (λₘₐₓ) in the wavelength range of 700 to 1,200 nm can easily absorb a laser beam and cause heat generation in the light-exposed portion. The term "maximum absorption wavelength" (hereinafter occasionally referred to as λₘₐₓ) used herein means the wavelength at which the maximum absorbance occurs in an absorption spectrum taken from a specimen prepared by dissolving the relevant compound in an appropriate solvent such as ethanol or dimethylformamide using an ultraviolet-visible-near infrared spectrophotometer (V-770, manufactured by JASCO Corporation).

Examples of the "(2) near-infrared absorbing compound" include dyes. Dyes are preferred from the viewpoint of efficient photothermal conversion. Examples thereof include those generally used for electronic devices and recorders such as cyanine based dyes, azlenium based dyes, squarylium based dyes, croconium based dyes, azo based dyes, bisazostilbene based dyes, naphthoquinone based dyes, anthraquinone based dyes, perylene based dyes, phthalocyanine based dyes, naphthalocyanine metal complex based dyes, polymethine based dyes, dithiol nickel complex based dyes, indoaniline metal complex dyes, intermolecular CT dyes, benzothiopyran based spiropyran, and nigrosine dyes.

Of these dyes, those having large values of the molar absorbance coefficient ε are preferred. Specifically, the ε value is preferably 1 × 10⁴ L/(mol·cm) or more, and more preferably 1 × 10⁵ L/(mol·cm) or more. An ε value of 1 × 10⁴ L/(mol·cm) or more ensures a high initial sensitivity. The value of this coefficient is on the basis of the active energy ray used for light exposure. To give specific wavelengths, it is better to note 780 nm, 808 nm, 830 nm, and 1,064 nm.

The heat-sensitive layer may contain two or more of these dyes. The incorporation of two or more dyes that give different λₘₐₓ wavelengths in the range of 700 to 1,200 nm allows for two or more lasers having different oscillation wavelengths.

Furthermore, these "(2) near-infrared absorbing compounds" preferably account for 1.0% by mass or more of the heat-sensitive layer. It is preferable that the near-infrared absorbing compounds have a total content of 1.0% by mass or more because the lithographic printing plate precursor irradiated with a laser beam will show an increased sensitivity. It is considered, furthermore, that the near-infrared absorbing compounds affects the decomposition of other components present in the vicinity, and therefore, such a content is preferable also because it can contribute to gas generation from the heat-sensitive layer. It is more preferable for the near-infrared absorbing compounds to account for 5.0% by mass or more of the heat-sensitive layer. It is preferable, on the other hand, that the content of the near-infrared absorbing compounds in the heat-sensitive layer is 40% by mass or less because it allows the heat-sensitive layer to maintain a higher solvent resistance and a higher peeling resistance. It is more preferable for the content of the near-infrared absorbing compounds in the heat-sensitive layer to be 30% by mass or less.

For the present invention, examples of the "(3) crosslinking agent" preferred for the heat-sensitive layer include organic complex compounds containing a metal and an organic compound other than the "(4) easily heat-decomposable compounds" described later. This is because they can act not only as crosslinking agents for the "(1) polymer having active hydrogen" but also as heat-decomposable compounds during crosslinking reaction to contribute to gas generation. Examples of such organic complex compounds include organic complex salts containing an organic ligand coordinated to a metal, organic-inorganic complex salts containing an organic ligand and an inorganic ligand coordinated to a metal, and metal alkoxides containing a metal and an organic molecule covalently bonded via oxygen. Of these organic complex compounds, metal chelates containing a ligand having two or more donor atoms to form a ring containing a metal atom are preferred from the viewpoint of the stability of the organic complex compounds themselves and the stability of the solution of the heat-sensitive layer composition.

Major preferred metals that can form organic complex compounds include Al (III), Ti (IV), Mn (II), Mn (III), Fe (II), Fe (III), Zn (II), and Zr (IV). Al (III) is particularly preferred because it serves effectively for improving the sensitivity, whereas Ti (IV) is particularly preferred because it serves effectively for developing resistance to printing inks or ink cleaning agents.

Furthermore, examples of the ligands include compounds that contain a coordinating group having oxygen, nitrogen, sulfur, etc., as donor atoms. Specific examples of such coordinating groups include those containing oxygen as donor atom such as -OH (alcohols, enols and phenols), -COOH (carboxylic acids), >C=O (aldehydes, ketones, quinones), -O-(ethers), -COOR (esters, R representing an aliphatic or aromatic hydrocarbon), -N=O (nitroso compounds); those containing nitrogen as donor atom include -NH₂ (primary amines, hydrazines), >NH (secondary amines), >N- (tertiary amines), -N=N- (azo compounds, heterocyclic compounds), and =N-OH (oximes); and those containing sulfur as donor atom such as -SH (thiols), -S- (thioethers), >C=S (thioketones, thioamides), and =S- (heterocyclic compounds).

Of the aforementioned organic complex compounds containing a metal and a ligand, those compounds which can be used suitably include complex compounds containing metals such as Al (III), Ti (IV), Fe (II), Fe (III), Zn (II), and Zr (IV) with β-diketones, amines, alcohols, or carboxylic acids, and particularly preferred complex compounds include acetylacetone complexes and acetoacetate ester complexes of Al (III), Fe (II), Fe (III), Ti (IV), or Zr (IV).

Specific examples of these compounds include those listed below: aluminum tris(acetylacetonate), aluminum tris(ethylacetoacetate), aluminum tris(propylacetoacetate), aluminum bis(ethylacetoacetate) mono(acetylacetonate), aluminum bis(acetylacetonate) mono(ethylacetoacetate), aluminum bis(propylacetoacetate) mono(acetylacetonate), aluminum bis(butylacetoacetate) mono(acetylacetonate), aluminum bis(propylacetoacetate) mono(ethylacetoacetate), aluminum dibutoxide mono(acetylacetonate), aluminum diisopropoxide mono(acetylacetonate), aluminum diisopropoxide mono(ethylacetoacetate), aluminum-s-butoxide bis(ethylacetoacetate), aluminum di-s-butoxide mono(ethylacetoacetate), titanium triisopropoxide mono(allylacetoacetate), titanium diisopropoxide bis(triethanol amine), titanium di-n-butoxide bis(triethanol amine), titanium diisopropoxide bis(acetylacetonate), titanium di-n-butoxide bis(acetylacetonate), titanium diisopropoxide bis(ethylacetoacetate), titanium di-n-butoxide bis(ethylacetoacetate), titanium tri-n-butoxide mono(ethylacetoacetate), titanium triisopropoxide mono(methacryloxy ethylacetoacetate), titanium dihydroxy bis(lactate), zirconium di-n-butoxide bis(acetylacetonate), zirconium tri-n-propoxide mono(methacryloxy ethylacetoacetate), zirconium tetrakis(acetylacetonate), iron(III) acetylacetonate, and iron(III) benzoylacetonate. Two or more of these may be contained together.

It is preferable that these organic complex compounds altogether account for 1% by mass or more of the heat-sensitive layer in order to serve as crosslinking agents for the polymer and allow the heat-sensitive layer to have a higher solvent resistance and a higher peeling resistance. On the other hand, they preferably account for 40% by mass or less in order to cause a sufficient degree of gas generation from the heat-sensitive layer so that the lithographic printing plate precursor can maintain a high resolution.

In the case where novolac resin is used as the polymer component of the heat-sensitive layer composition, the mass ratio of the novolac resin to the organic complex compound is preferably 2.0 or more, more preferably 2.5 or more, and still more preferably 3.0 or more because the lithographic printing plate precursor maintains a high resolution while preventing the crosslinked structure of the novolac resin from becoming too dense. On the other hand, the mass ratio of the novolac resin to the organic complex compound is preferably 6.0 or less, more preferably 5.5 or less, and still more preferably 5.0 or less, in order to ensure a higher solvent resistance and a higher peeling resistance of the heat-sensitive layer.

For the present invention, the "(4) easily heat-decomposable compound" that can be used suitably in the heat-sensitive layer is a compound having a heat degradation onset temperature of 450°C or less and shows a weight reduction at 450°C or less in the TG/DTA curve of the compound observed by a simultaneous thermogravimetry/differential thermal analysis apparatus. Organic examples of such a compound include azo compounds such as azodicarbonamide and diazoaminobenzene; hydrazine derivatives such as hydrazodicarbonamide, 4,4'-oxybis(benzenesulfonyl hydrazide), and p-toluenesulfonyl hydrazide; nitroso compounds such as N,N'-dinitrosopentamethylene tetramine; semicarbazide compounds such as toluenesulfonyl semicarbazide; dyes such as cyanine based ones, phthalocyanine based ones, triphenylmethane based ones, thiazine based ones, azo based ones, and fluoresceins; water-soluble vitamins such as ascorbic acid and riboflavin; and fat-soluble vitamins such as retinol and β-carotene; whereas inorganic examples include hydrogen carbonates such as sodium hydrogen carbonate.

In addition, it is more preferable that the "(4) easily heat-decomposable compound" is a compound that has a nature of being directly heat-decomposed without going through a melting stage. Whether or not a compound has this nature can be determined by extracting the compound with a good solvent from the heat-sensitive layer of the lithographic printing plate precursor and examining the extracted compound by the TG/DTA method using a simultaneous thermogravimetry/differential thermal analysis apparatus. The measuring procedure will be described in detail in the section of Examples.

For the present invention, the incorporation of an easily heat-decomposable compound that has a nature of being directly heat-decomposed without going through a melting stage in the heat-sensitive layer serves to efficiently enhance the gas generation and thereby contribute to increasing the sensitivity of the heat-sensitive layer. This is considered to be because the heat generated from the near-infrared absorbing compound is absorbed by the "(4) easily heat-decomposable compound" and used efficiently for heat decomposition instead of using it for another change of state, i.e. melting.

Of the variety of "(4) easily heat-decomposable compounds" having the aforementioned nature, those not having a maximum absorption wavelength (λₘₐₓ) in the wavelength range of 700 to 1,200 nm are more preferable. It is considered that compounds not having a maximum absorption wavelength (λₘₐₓ) in the wavelength range of 700 to 1,200 nm are unlikely to generate excessive heat from a light-exposed region due to the difficulty in absorbing a laser beam. Therefore, since the propagation of heat to unexposed regions adjacent to the exposed region is less likely to occur, the heat-sensitive layer may not suffer significant destruction in the unexposed regions adjacent to the light-exposed region, possibly preventing a decrease in the solvent resistance of the printing plate precursor.

These "(4) easily heat-decomposable compounds" preferably account for 0.1% by mass to 40% by mass, more preferably 1.0% by mass to 30% by mass, and still more preferably 3.0% by mass to 20% by mass, of the heat-sensitive layer. If the "(4) easily heat-decomposable compounds" have a content of 1.0% by mass or more, it will contributes to enhancement of the gas generation from the heat-sensitive layer and further improvement in the sensitivity to a laser beam. If it is 40% by mass or less, on the other hand, it serves to allow the heat sensitive layer to maintain a higher solvent resistance and a higher peeling resistance.

Furthermore, these "(4) easily heat-decomposable compounds" preferably have a heat decomposition temperature of 100°C to 450°C, more preferably 130°C to 400°C, still more preferably 140°C to 350°C, still more preferably 150°C to 350°C, and most preferably 150°C to 300°C. The use of a "(4) easily heat-decomposable compound" having a heat decomposition temperature of 100°C or more serves to allow the heat-sensitive layer to maintain a higher solvent resistance because a certain amount of the "(4) easily heat-decomposable compound" remains undecomposed even after the production of the lithographic printing plate precursor. If the "(4) easily heat-decomposable compound" has a heat decomposition temperature of 450°C or less, it allows the heat-sensitive layer to have a higher sensitivity. The heat decomposition temperature of a "(4) easily heat-decomposable compound" can be determined by the TG/DTA method using a simultaneous thermogravimetry/differential thermal analysis apparatus. The measuring procedure will be described in detail in the section of Examples.

Specific examples of the "(4) easily heat-decomposable compounds" that are heat-decomposed after melting include triphenylmethane based dyes such as phenolphthalein, methyl violet, ethyl violet, crystal violet lactone, and thymolphthalein; thiazine based dyes such as phenothiazine and benzoyl leucomethylene blue; azo based dyes such as p-phenylazophenol, methyl red, methyl orange, oil orange SS, and oil red; fluoresceins such as carboxyfluorescein and uranine; and vitamins such as riboflavin tetrabutyrate. On the other hand, compounds that have a nature of being directly heat-decomposed without going through a melting stage include flavonoids such as catechin hydrate; triphenyl methane based dyes such as basic fuchsin, light green SF yellow, basic red 9, cresol red, malachite green oxalate, brilliant green, victorial blue B, crystal violet, bromocresol purple, bromocresol green sodium salt, thymol blue, bromocresol green, bromothymol blue sodium salt, tetrabromophenol blue, and bromothymol blue; thiazine based dyes such as methylene blue; azo based dyes such as congo red, oil red 5B, and methyl yellow; xanthene based dyes such as rhodamine B, rhodamine 6G, fluorescein, fluorescein isothiocyanate, fluorescein-5-maleimide, diiodofluorescein, and dichlorofluorescein; and vitamins such as riboflavin and ascorbic acid. Of these, thymol blue, bromocresol green, bromothymol blue sodium salt, tetrabromophenol blue, bromothymol blue, basic fuchsin, (L+)-ascorbic acid, and malachite green oxalate are preferred.

For the lithographic printing plate precursor according to the present invention, furthermore, the heat-sensitive layer may contain various additives if necessary. For example, a silicone based surfactant, a fluorine based surfactant, or the like may be contained in order to improve the coatability. In addition, a silane coupling agent, a titanium coupling agent, or the like may also be contained in order to enhance the adhesion to the ink repellent layer. Depending on the intended uses, it is generally preferable that the content of these additives is 0.1% by mass to 30% by mass relative to the total solid content in the heat-sensitive layer.

For the lithographic printing plate precursor according to the present invention, the average thickness of the heat-sensitive layer is preferably 0.2 µm or more, more preferably 0.5 µm or more, and still more preferably 0.7 µm or more in order to cause sufficient gas generation to allow the lithographic printing plate precursor to maintain a high resolution. On the other hand, it is preferably 10.0 µm or less, more preferably 5.0 µm or less, and still more preferably 3.0 µm or less in order to allow the heat-sensitive layer to maintain a high solvent resistance and a high peeling resistance. Here, the average thickness of the heat-sensitive layer can be determined by cross-sectional scanning electron microscopy. More specifically, a section of a lithographic printing plate precursor is embedded in resin and a cross section is prepared by ion milling (BIB technique) and observed by cross-sectional scanning electron microscopy using a field emission type scanning electron microscope (FE-SEM) (SU8020, manufactured by Hitachi High-Technologies Corporation) to determine the thickness. Ten positions are randomly selected from the area of the heat-sensitive layer being observed by cross-sectional scanning electron microscopy and the number average of the measurements taken is calculated to represent the average thickness.

For the lithographic printing plate precursor according to the present invention, the ink repellent layer is preferably a silicone rubber layer, specifically a layer of crosslinked polyorganosiloxane. It is preferable, furthermore, that the silicone rubber in the silicone rubber layer has a structure derived from the following: (a) an SiH group-containing compound and (b) a vinyl group-containing polysiloxane.

The silicone rubber layer may be produced by, for example, coating with an addition reaction type silicone rubber layer composition or a condensation reaction type silicone rubber layer composition or coating with a solution of such a composition followed by (heating) drying.

It is preferable for the addition reaction type silicone rubber layer composition to contain at least a "(b) vinyl group-containing polysiloxane", a "(a) SiH group-containing compound" (addition reaction type crosslinking agent) having a plurality of hydrosilyl groups, and a curing catalyst. In addition, a reaction inhibitor may also be contained. Furthermore, it is preferable that the "(b) vinyl group-containing polysiloxane" is a vinyl group-containing organopolysiloxane.

In the addition reaction type silicone rubber, a siloxane unit as represented by the following general formula (II) is newly formed as a crosslinking point for the silicone rubber through the reaction between the "(a) SiH group-containing compound" and "(b) vinyl group-containing polysiloxane". The crosslink density of the silicone rubber can be estimated from the molar ratio (ratio of (II)/(I) by mole) of the siloxane unit represented by the following general formula (II) to the dimethylsiloxane unit represented by the following general formula (I), which is the base component of the silicone rubber. In addition, regarding the molar ratio (II)/(I) of the siloxane units, the silicone rubber is examined by solid-state ²⁹Si NMR spectroscopy and the ratio of the peak area attributed to the siloxane unit Si** represented by the following general formula (II) to the peak area attributed to the dimethylsiloxane unit Si* represented by the following general formula (I), that is, the peak area ratio [(II) peak area attributed to Si** / (I) peak area attributed to Si*], is calculated to determine the molar ratio (II)/(I) of the siloxane units. The measuring procedure will be described in detail in the section of Examples.

-Si*(CH₃)₂-O- (I)

-Si(CH₃)₂-CH₂-CH₂-Si**(CH₃)₂-O- (II)

The above molar ratio (II)/(I) of the siloxane units, that is, the peak area ratio [(II) peak area attributed to Si** / (I) peak area attributed to Si*], is preferably 0.00240 or more, more preferably 0.00245 or more, from the viewpoint of maintaining a required resolution. On the other hand, it is preferably 0.00900 or less, more preferably 0.00880 or less, and still more preferably 0.00500 or less, because the crosslinked structure of the silicone rubber will not be too dense and a deterioration in developability can be prevented.

Such "(b) vinyl group-containing polysiloxanes" have a structure as represented by the following general formula (b1) and have a vinyl group at a terminal of the main chain or as a substituent on a hydrocarbon group bonded to the silicon atom. In particular, those having a vinyl group at a terminal of the main chain are preferred. Two or more of these may be contained together.

-(SiR¹R²-O-)ₙ- (b1)

In the formula, n represents an integer of 2 or more, and R¹ and R² may be identical to or different from each other and each represent a saturated or unsaturated hydrocarbon group having 1 to 50 carbon atoms. Each hydrocarbon group may be linear, branched, or cyclic and may contain an aromatic ring. The plurality of R¹'s present in a polysiloxane molecule as represented by the general formula (b1) may be identical to or different from each other. Also, the plurality of R²'s present in a polysiloxane molecule as represented by the general formula (b1) may be identical to or different from each other.

Examples the "(a) SiH group-containing compound" include organohydrogen polysiloxanes and organic polymers having a diorganohydrogen silyl group, of which organohydrogen polysiloxane is preferred. Two or more of these may be contained together.

The organohydrogen polysiloxanes may have linear, cyclic, branched, or network molecular structures. Examples include a polymethylhydrogen siloxane with both chain ends capped with trimethylsiloxy groups, a dimethylsiloxane-methylhydrogen siloxane copolymer with both chain ends capped with trimethylsiloxy groups, and a dimethylpolysiloxane with both chain ends capped with dimethylhydrogen siloxy groups.

From the viewpoint of curability of the silicone rubber layer, the content of the "(a) SiH group-containing compound" is preferably 0.5% by mass or more, more preferably 1% by mass or more, in the silicone rubber layer composition. On the other hand, it is preferably 20% by mass or less, more preferably 15% by mass or less.

Reaction inhibitors that can be used in an addition reaction type silicone rubber layer composition include nitrogen-containing compounds, phosphorus based compounds, and unsaturated alcohols, and in particular, acetylene group-containing alcohols are preferred. Two or more of these may be contained together. For use in an addition reactive silicone-rubber layer composition, an appropriate curing catalyst may be selected from commonly used ones. It is preferable to use platinum based compounds, and specific examples thereof include platinum, platinum chloride, chloroplatinic acid, olefin-coordinated platinum, alcohol-modified complexes of platinum, and methylvinylpolysiloxane complexes of platinum. Two or more of these may be contained together.

In addition to these components, the addition reaction type silicone rubber layer composition may also contain a hydroxyl group-containing organopolysiloxane, a hydrolyzable functional group-containing silane, a siloxane containing such a functional group, an ordinary filler such as silica for improving rubber strength, and an ordinary silane coupling agent for improving adhesiveness. Preferred examples of the silane coupling agent include alkoxysilanes, acetoxysilanes, and ketoxiiminosilanes, and it is preferable that a vinyl group or an allyl group is directly bonded to the silicon atom.

It is preferable for the condensation reaction type silicone rubber layer composition to be formed from at least a hydroxyl group-containing organopolysiloxane, crosslinking agent, and curing catalyst as raw materials.
Such a hydroxyl group-containing organopolysiloxane has a structure as represented by the aforementioned general formula (b1) and has a hydroxyl group at a terminal of the main chain or as a substituent on a hydrocarbon group bonded to the silicon atom. In particular, it is preferable for them to have a hydroxyl group at a terminal of the main chain. Two or more of these may be contained together.

Examples of the crosslinking agent to be added in the condensation reaction type silicone rubber layer composition include deacetated type, deoximated type, dealcoholized type, deacetonated type, deamidated type, and dehydroxylaminated type silicon compounds as represented by the following general formula (III).

(R³)₄₋ₘSiXₘ (III)

In the formula, m represents an integer of 2 to 4, and R³'s may be identical to or different from each other and each represent a substituted or unsubstituted alkyl group having 1 or more carbon atoms, an alkenyl group, an aryl group, or a group in the form of a combination thereof. X's, which may be identical to or different from each other, each represent a hydrolyzable group. Examples of the hydrolyzable group include acyloxy groups such as acetoxy group, ketoxime groups such as methyl ethyl ketoxime group, and alkoxy groups such as methoxy group, ethoxy group, propoxy group, and butoxy group. In the above formula, m, which represents the number of hydrolyzable groups, is preferably 3 or 4.

From the viewpoint of the stability of the silicone rubber layer composition and the solution, the content of the crosslinking agent in the condensation reaction type silicone rubber layer composition is preferably 0.5% by mass or more, more preferably 1% by mass or more, in the silicone rubber layer composition. On the other hand, from the viewpoint of strength of the silicone rubber layer and scratch resistance of the lithographic printing plate precursor, its content is preferably 20% by mass or less, more preferably 15% by mass or less, in the silicone rubber layer composition.

Examples of the curing catalyst added in the condensation reaction type silicone rubber layer composition include dibutyltin diacetate, dibutyltin dioctate, dibutyltin dilaurate, zinc octylate, and iron octylate. Two or more of these may be contained together.

The ink repellent layer of the lithographic printing plate precursor according to the present invention may contain an ink repellent liquid in order to increase the resolution or to enhance the ink repellency. It is preferable for the ink repellent liquid to have a boiling point of 150°C or more at 1 atm. Since the crosslinked structure of the ink repellent layer becomes weaker during the production of the precursor, the ink repellent layer can be removed more easily in the development step to realize an increased resolution. When the plate surface is pressurized at the time of printing, furthermore, the ink repellent liquid is pushed to the surface of the ink repellent layer to help the removal of the ink, thereby enhancing the ink repellency. If having a boiling point of 150°C or more, the ink repellent liquid will not be volatilized during the production of the lithographic printing plate precursor and the ink repellency effect brought about by its addition will not be significantly marred.

The addition of the liquid described above to the ink repellent layer serves to increase the resolution and ink repellency, but its content in the silicone rubber layer is preferably 10% by mass or more and 35% by mass or less. If its content is 10% by mass or more, the resolution and ink repellency are remarkably improved, whereas if it is 35% by mass or less, it allows the silicone rubber layer to have a sufficiently high strength and maintain printing resistance.

The aforementioned ink repellent liquid is preferably a silicone compound, and more preferably a silicone oil. For the present invention, the silicone oil refers to a polysiloxane component that is not involved in the crosslinks in the ink repellent layer. Thus, examples include dimethyl silicone oils such as dimethyl-terminated polydimethyl siloxane, cyclic polydimethyl siloxane, and dimethyl-terminated polydimethyl-polymethylphenyl siloxane copolymer and modified silicone oils in the form of alkyl-modified silicone oils, fluorine-modified silicone oils, and polyether-modified silicone oils in which various organic groups are introduced in some of the methyl groups in the molecules thereof.

There are no specific limitations on the molecular weight of these silicone oils, but it is preferable for them to have a weight average molecular weight Mw of 1,000 to 100,000 as measured by gel permeation chromatography (GPC) using polystyrene as reference.

For the lithographic printing plate precursor according to the present invention, the average thickness of the silicone rubber layer, which serves as ink repellent layer, is preferably 0.5 to 20 µm, more preferably 3 to 20 µm, and still more preferably 3.5 to 10 µm. The silicone rubber layer will have a sufficient ink repellency, scratch resistance, and printing durability if it has an average thickness of 0.5 µm or more, whereas there will be no economic disadvantages and significant deterioration in image developability or inking quantity will not occur if it has a thickness of 20 µm or less. Here, the average thickness of the silicone rubber layer can be determined by transmission electron microscopy. More specifically, a specimen is prepared by the ultrathin sectioning method from a lithographic printing plate precursor and observed by transmission electron microscopy under the conditions of an accelerating voltage of 100 kV and a direct magnification of 2,000x to determine the layer thickness. Ten positions are randomly selected on the silicone rubber layer and the thickness is measured at each of them. Then, the number average of the measurements is calculated to represent the average layer thickness.

In the lithographic printing plate precursor according to the present invention, a protective film and/or interleaving paper may be provided on the surface of the ink repellent layer in order to protect the ink repellent layer.

The protective film is preferably a film having a thickness of 100 µm or less and transmitting light having the same wavelength as the light source used for light exposure. Examples of film materials include polyethylene, polypropylene, polyvinyl chloride, polyethylene terephthalate, and cellophane. In addition, in order to prevent the precursor from sensing the light used for light exposure, a variety of light absorbers, photochromic substances, and photobleaching substances as described in Japanese Patent No. 2938886 may be provided on the protective film.

The interleaving paper preferably has a weight of 30 to 120 g/m², more preferably 30 to 90 g/m². If the interleaving paper has a weight of 30 g/m² or more, it will have a sufficient mechanical strength, whereas if its weight is 120 g/m² or less, such a weight will not only have economic advantages but also allow the lithographic printing plate precursor and the paper to form a thinner stack, thereby leading to a higher workability. Examples of preferred interleaving paper products include, but not limited to, information recording base paper 40 g/m² (manufactured by Nagoya Pulp Corporation), metallic interleaving paper 30 g/m² (manufactured by Nagoya Pulp Corporation), unbleached kraft paper 50 g/m² (manufactured by Chuetsu Pulp & Paper Co., Ltd.), NIP paper 52 g/m² (manufactured by Chuetsu Pulp & Paper Co., Ltd.), pure white roll paper 45 g/m² (manufactured by Oji Paper Co., Ltd.), and clupak 73 g/m² (manufactured by Oji Paper Co., Ltd.).

Next, the method for producing a lithographic printing plate from the lithographic printing plate precursor according to the present invention is described below. To produce a lithographic printing plate, the lithographic printing plate precursor described above is processed by a method including whether the step (1) or the step (2) described below:
step (1) including a step (A) for performing light exposure according to an image (light exposure step), and
step (2) including the step (A) for performing light exposure and a subsequent step (B) for applying physical friction to the light-exposed lithographic printing plate precursor to remove the ink repellent layer in the light-exposed region (development step).
The resulting lithographic printing plate is the remainder of the lithographic printing plate precursor left after removing a part of the ink repellent layer that corresponds to the light exposure image on the surface.

First, the light exposure step (A) is described below. In the light exposure step (A), the lithographic printing plate precursor is exposed to light according to an image. In the case of a lithographic printing plate precursor having a protective film, light may be applied through the protective film or after removing the protective film. For the light exposure step (A), it is preferable to use a light source in the emission wavelength range of 300 to 1,500 nm. In particular, the use of a semiconductor laser or a YAG laser having an emission wavelength range near the near infrared region is preferred because wavelengths in this range are widely adopted as absorption wavelengths of heat-sensitive layers. Specifically, laser beams having wavelengths of 780 nm, 808 nm, 830 nm, or 1,064 nm are used suitably for light exposure from the viewpoint of the efficiency of conversion into heat.

Next, the development step (B) is described below. In the development step (B), physical friction is applied to the light-exposed lithographic printing plate precursor to remove the ink repellent layer in the light-exposed region. Useful methods for applying physical friction include (i) a method of wiping the plate surface with a nonwoven fabric, absorbent cotton, cloth, sponge, or the like, containing a developing liquid, (ii) a method of pre-treating the plate surface with a developing liquid and subsequently rubbing it with a rotating brush in a shower of tap water or the like, and (iii) a method of applying a jet of high pressure water, warm water, or water vapor onto the plate surface.

Prior to development, the lithographic printing plate precursor may be pre-treated by immersing it in a pre-treatment liquid for a certain period of time. Examples of the pre-treatment liquid include water, water containing a polar solvent such as alcohol, ketone, ester, or carboxylic acid, a solution prepared by adding a polar solvent to a solvent containing at least one of aliphatic hydrocarbons, aromatic hydrocarbons, and the like, and polar solvents. Another example of the pre-treatment liquid is one that contains a polyethylene ether diol and a diamine compound having two or more primary amino groups as described in Japanese Patent No. 4839987. More specific examples of the pre-treatment liquid include PP-1, PP-3, PP-F, PP-FII, PTS-1, CP-1, CP-Y, NP-1, and DP-1 (all manufactured by Toray Industries, Inc.).

For example, the developing liquid may be water, an aqueous solution in which water accounts for 50% by mass or more of the entire solution, an alcohol, or a paraffinic hydrocarbon. Other examples include mixtures of water and propylene glycol derivatives such as propylene glycol, dipropylene glycol, triethylene glycol, polypropylene glycol, and alkylene oxide adducts to polypropylene glycol. More specific examples of the developing liquid include HP-7N and WH-3 (both manufactured by Toray Industries, Inc.). A conventional surfactant may also be added as a component of the developing liquid. From the viewpoint of safety, disposal cost, and the like, it is desirable to use a surfactant that forms an aqueous solution having a pH of 5 to 8. The surfactant preferably accounts for 10% by mass or less of the developing liquid. Such a developing liquid is very safe and also preferred in terms of economical features such as disposal cost.

In addition, in order to ensure a high visibility of the image area and a high measurement accuracy for the halftone dots, the pre-treatment solution or the developing solution may contain a dye such as crystal violet, Victoria pure blue, or Astrazone red so that the ink absorbing layer in the image area is dyed while being developed. Instead, the layer may be dyed after development using a liquid containing a dye as listed above.

A part or the entirety of the above development step can be automated using an automatic developing machine. The automatic developing machine may be an apparatus as listed below: an apparatus containing only a developing unit, an apparatus containing a pre-treating unit and a developing unit in this order, an apparatus containing a pre-treatment unit, a developing unit, and a post-treatment unit in this order, and an apparatus containing a pre-treatment unit, a developing unit, a post-treatment unit, and a rinsing unit in this order. Specific examples of such an automatic developing machine include the TWL-650 series, TWL-860 series, and TWL-1160 series (all manufactured by Toray Industries, Inc.), and an automatic developing machine equipped with a bearer having a curved dent to reduce scratches on the back of the plate as described in Japanese Unexamined Patent Publication (Kokai) No. HEI 5-6000. These may be used in combination.
In preparation for storing the developed lithographic printing plates stacked in a pile, it is preferable to provide interleaving paper sheets between the plates in order to protect the plate surfaces.

Next, as a typical process for producing printed matter using the lithographic printing plate according to the present invention, there is a printed matter production method that consists of a step for adhering ink to the surface of a lithographic printing plate and a step for transferring the ink either directly or via a blanket to an object to be printed. The lithographic printing plate according to the present invention can be applied to both water-based printing and waterless printing, but it is more suited to waterless printing, which is performed without dampening water, from the viewpoint of the quality of printed matter. The layer remaining after removing the ink repellent layer from a heat-sensitive layer then serves as an ink absorbing layer and this forms an Image area. The ink repellent layer leaves the non-image area. The ink absorbing layer and the ink repellent layer are substantially flush with each other with a step of only several micrometers. Due to the difference in adhesiveness to the ink, the ink is allowed to adhere to only the image area, and then the ink is transferred to the object to be printed. The object to be printed may be art paper, coated paper, cast-coated paper, synthetic paper, cloth paper, newspaper, aluminized paper, metal, plastic film, etc. Examples of the plastic film include plastic film of polyethylene terephthalate, polyethylene, polyester, polyamide, polyimide, polystyrene, polypropylene, polycarbonate, polyvinyl acetal, etc.; plastic film laminated paper formed of paper laminated with a plastic film as listed above; metallized plastic film formed of plastic film on which metal such as aluminum, zinc, copper, etc., is deposited. When producing printed matter using the lithographic printing plate according to the present invention, non-absorbent raw materials such as synthetic paper, cloth paper, metal, and plastic film are used suitably.

Here, ink may be transferred either directly or via a blanket to an object to be printed. A printing process using the lithographic printing plate according to the present invention may also include a step for applying active energy ray to the ink transferred to the object to be printed. This step may use an ink that is curable by active energy ray. An ink that can be cured by ultraviolet ray irradiation (hereinafter referred to as UV ink) commonly contains photosensitive components that cause polymerization reaction when exposed to ultraviolet ray, such as reactive monomers, reactive oligomers, photopolymerization initiators, and, if necessary, sensitizers. For UV printing using a lithographic printing plate, it is preferable that the photosensitive components account for 10% by mass or more and 50% by mass or less of the ink. If the photosensitive components account for less than 10% by mass, the curing rate will be slow and the printed sheets will be stacked while the UV ink is not cured completely, thus easily causing offset. On the other hand, the ink repellency decreases with an increasing proportion of the photosensitive components, and if the photosensitive components account for more than 50% by mass, ink residues tend to remain significantly in the image area.

In order to increase the ink repellency, it may be effective to use a UV ink containing an acrylic ester or a methacrylic ester having a linear alkyl group. Such a linear alkyl group preferably contains 9 or more carbon atoms. Specific examples of the acrylic ester having a linear alkyl group include nonyl acrylate, decyl acrylate, undecyl acrylate, dodecyl acrylate, tridecyl acrylate, tetradecyl acrylate, pentadecyl acrylate, hexadecyl acrylate, heptadecyl acrylate, octadecyl acrylate, and isooctadecyl acrylate. Specific examples of the methacrylic ester having a linear alkyl group include nonyl methacrylate, decyl methacrylate, undecyl methacrylate, dodecyl methacrylate, tridecyl methacrylate, tetradecyl methacrylate, pentadecyl methacrylate, hexadecyl methacrylate, heptadecyl methacrylate, and octadecyl methacrylate.

It is preferable for the content of these acrylic esters or methacrylic esters having a linear alkyl group to be 0.5% by mass or more, more preferably 1% by mass or more, relative to the total quantity of UV ink to ensure a high ink repellency. On the other hand, it is preferably 15% by mass or less, more preferably 10% by mass or less, to allow the UV ink to be cured efficiently.

Any type of active energy ray may be used to irradiate the UV ink as long as it has an excitation energy required to cause curing reaction, and preferred examples include ultraviolet ray and electron beam. When an electron beam is used for curing, it is preferable to adopt an electron beam irradiation apparatus that can produce an electron beam of 100 to 500 eV. When an ultraviolet ray is used for curing, preferred ultraviolet ray irradiation apparatuses include high pressure mercury lamp, xenon lamp, metal halide lamp, and LED, although there are no specific limitations thereon.
The present invention will now be illustrated with reference to Examples, but the present invention should not be construed as being limited thereto.

### EXAMPLES

### (1) Evaluation of easily heat-decomposable compounds in terms of whether they have a nature of being directly heat-decomposed without going through a melting stage

An easily heat-decomposable compound was examined by a simultaneous thermogravimetry/differential thermal analysis apparatus (TG/DTA6200, manufactured by Seiko Instruments Inc.) to give a TG/DTA curve by heating from 30°C to 500°C at a rate of 10°C/min in a nitrogen atmosphere flowing at 80 mL/min. A compound was judged to have a nature of being directly heat-decomposed without going through a melting stage if shown by the resulting TG/DTA curve to be heat-decomposable but not giving a melting peak before undergoing a weight loss at 100°C or more (i.e., an endothermic peak not accompanied by a weight loss), and it is given a "no" in the column for "melting before heat decomposition" in Table 1, which will be described later. On the other hand, a compound was judged not to have a nature of being heat-decomposed without going through a melting stage if giving a melting peak before undergoing a weight loss at 100°C or more, and it is given a "yes" in the column for "melting before heat decomposition" in Table 1.

### (2) Measurement of heat decomposition temperature of easily heat-decomposable compound

An easily heat-decomposable compound was examined by a simultaneous thermogravimetry/differential thermal analysis apparatus (TG/DTA6200, manufactured by Seiko Instruments Inc.) to give a TG/DTA curve by heating from 30°C to 500°C at a rate of 10°C/min in a nitrogen atmosphere flowing at 80 mL/min. In the TG/DTA curve obtained, the point of 100°C or more at which weight loss started was measured as heat decomposition temperature.

### (3) Measurement of thickness of heat sensitive layer

A section of a lithographic printing plate precursor was embedded in resin and a cross section was prepared by ion milling (BIB technique). Observation was performed using a field emission type scanning electron microscope (FE-SEM) (SU8020, manufactured by Hitachi High-Technologies Corporation) at an accelerating voltage of 3.0 kV and a magnification of 10.0 k times. Ten positions were randomly selected in each of three areas of the heat-sensitive layer observed by cross-sectional scanning electron microscopy and the thickness was measured. Then, the number average of the measurements taken was calculated to represent the average thickness Z (µm).

### (4) Measurement of rate of gas generation

Measurement of the rate of gas generation was performed using a thermal desorption apparatus (TD-100, manufactured by Markes) and a GC-MS apparatus (7890A+5975C, manufactured by Agilent). A 10 mm × 10 mm sample cut out from the lithographic printing plate precursor according to the present invention was put in a glass container, and it was heated in a heating furnace set to a temperature of 450°C and an N₂ flow rate of 100 mL/min while collecting the generated gas components in an adsorption pipe (collection time 5 minutes).

This adsorption pipe containing collected gas and another adsorption pipe containing a diluted standard (toluene) were connected to the column and heated at 260°C to introduce the gas components into the column (0.25 mm inside diameter × 30 m). Then, the column was heated from 40°C (maintained for 4 minutes) to 280°C (maintained for 22 minutes) at a rate of 10°C/min, and measurement was performed at a He flow rate of 1.5 mL/min over the scanning range m/z of 29 to 600. A calibration curve was prepared based on the absolute quantity of the standard and the measured peak area, and it was used for qualitative and quantitative analysis. The generated gas mainly consisted of components derived from the heat-sensitive layer and those derived from the ink repellent layer, and the rate of gas generation was calculated by the following formula (III) wherein Y (µg) is the total quantity of the decomposition products of the polymer, decomposition products of the crosslinking agent, decomposition products of the near-infrared absorbing compound, and decomposition products of the easily heat-decomposable compound, which were derived from the heat-sensitive layer, and Z (µm) is the average thickness of the heat-sensitive layer.

Rate of gas generation (g/m³) = (Y/Z) × 10⁴ (III)

### (5) Evaluation for resolution

The lithographic printing plate precursor prepared in each Example was irradiated with an irradiation energy of 214 mJ/cm² (drum rotating speed 140 rpm) using a light exposure machine for CTP (PlateRite 8800E, manufactured by Dainippon Screen Mfg. Co., Ltd.). Then, 1 to 99% halftone dots were formed at 2,400 dpi and 175 Ipi in the center of a 550 mm long × 650 mm wide sample of the lithographic printing plate precursor. Without using a pre-treatment liquid, the light-exposed precursor was sent at a speed of 60 cm/min to an automatic developing machine (TWL-1160F, manufactured by Toray Industries, Inc.) in which it was subjected to chemical-free developing using tap water as developing liquid to produce a lithographic printing plate. For the resulting lithographic printing plate, 1% and 2% halftone dots were observed under an optical microscope (ECLIPSE L200N, manufactured by Nikon Corporation), and the proportion of reproduced dots was determined to represent the resolution. The plate can be used practically without problems if the resolution is 70% or more for 2% halftone dots. It is preferably 80% or more for 2% halftone dots, more preferably 100% for 2% halftone dots, and still more preferably 100% for 2% halftone dots and 30% or more for 1% halftone dots.

### (6) Evaluation for solvent resistance

The lithographic printing plate precursor prepared in each Example was irradiated with an irradiation energy of 125 mJ/cm² (drum rotating speed 240 rpm) using a light exposure machine for CTP (PlateRite 8800E, manufactured by Dainippon Screen Mfg. Co., Ltd.). A 20 mm long × 650 mm wide strip-shaped solid image was disposed in the center of a 550 mm long × 650 mm wide sample of the lithographic printing plate precursor. Using DP-1 (manufactured by Toray Industries, Inc., 37°C) as pre-treatment liquid, it was sent at a speed of 80 cm/min through an automatic developing machine (TWL-1160F, manufactured by Toray Industries, Inc.) in which tap water was used as developing liquid to produce a lithographic printing plate. The resulting lithographic printing plate was observed visually and rated as 5, 4, 3, 2, or 1 if the area deprived of silicone rubber in the unexposed region accounted for 0%, more than 0% and less than 5%, 5% or more and less than 10%, 10% or more and less than 20%, or 20% or more and less than 50%, respectively. A sample getting a higher mark has a higher solvent resistance, and it can serve practically without problems if getting 3 or higher.

### (7) Evaluation for peeling resistance of heat-sensitive layer

The lithographic printing plate precursor prepared in each Example was irradiated with an irradiation energy of 214 mJ/cm² (drum rotating speed 140 rpm) using a light exposure machine for CTP (PlateRite 8800E, manufactured by Dainippon Screen Mfg. Co., Ltd.). A 20 mm long × 650 mm wide strip-shaped solid image was disposed in the center of a 550 mm long × 650 mm wide sample of the lithographic printing plate precursor. Without using a pre-treatment liquid, the light-exposed precursor was sent at a speed of 60 cm/min through an automatic developing machine (TWL-1160F, manufactured by Toray Industries, Inc.) in which tap water was used as developing liquid to produce a lithographic printing plate. A boundary portion of the solid image in the resulting lithographic printing plate was observed under an ultra-depth color 3D profiling microscope (VK-9510, manufactured by KEYENCE Corporation) and rated respectively as 5, 4, 3, 2, or 1 if the surface roughness (Ra) of the light-exposed portion of the heat-sensitive layer was 0 µm or more and less than 0.20 µm, 0.20 µm or more and less than 0.30 µm, 0.30 µm or more and less than 0.40 µm, 0.40 µm or more and less than 0.50 µm, or 0.50 µm or more and less than 1.0 µm. A sample getting a higher mark is higher in terms of the peeling resistance of the heat-sensitive layer, and it can serve practically without problems if getting 3 or higher.

### (8) Determination of crosslink density of silicone rubber

The crosslink density of silicone rubber is determined based on solid ²⁹Si NMR analysis. Silicone rubber was scraped off from the lithographic printing plate precursor and subjected to solid ²⁹Si NMR measurement by the DD/MAS method using AVANCE400 (manufactured by Bruker) under the conditions of the use of ²⁹Si as measuring nuclide, spectrum band width of 40 kHz, pulse width of 4.2 µsec, pulse repetition period of 0.02049 sec for ACQTM and 140 sec for PD, observation point of 8192, standard substance of hexamethyl cyclotrisiloxane (external standard -9.66 ppm), temperature of 22°C, and specimen rotation speed of 4 kHz.

For the resulting ²⁹Si DD/MAS NMR spectrum, the peak near a chemical shift of -22 ppm was attributed to the dimethyl siloxane unit represented by the following general formula (I), i.e. the base component of the silicone rubber, and the peak near 7-8 ppm was attributed to the siloxane unit represented by the following general formula (II), i.e. the crosslinking points.

-Si*(CH₃)₂-O- (I)

-Si(CH₃)₂-CH₂-CH₂-Si**(CH₃)₂-O- (II)

The peak area ratio of the "(II) peak area" attributed to Si** as described above to the "(I) peak area" attributed to Si* (i.e. the molar ratio of (II)/(I)) was calculated to represent the crosslink density.

### (9) Printing test

The lithographic printing plate precursors 3, 20, and 22 described in the relevant Examples were exposed to light and developed to prepare printing plates. Each of them was then mounted on a web offset press (MHL13A, manufactured by Miyakoshi Printing Machinery Co., Ltd.) and used to print a 2,000 m portion of an OPP film (Pilen (registered trademark) P2111, thickness 20 µm, corona-treated, manufactured by TOYOBO Co., Ltd.) at a printing speed of 50 m/min using a lithographic printing ink. With reference to Example 43 described in Japanese Unexamined Patent Publication (Kokai) No. 2019-052319, the lithographic printing ink was prepared by weighing the ink components specified below and passing them through a triple roll mill (EXAKT (registered trademark) M-80S, manufactured by EXAKT, set to gap 1) three times.
Lionol Blue FG7330 (TOYOCOLOR Co., Ltd.) 18.0 parts by mass
MICRO ACE (registered trademark) P-3 (manufactured by Nippon Talc Co., Ltd.) 1.0 parts by mass
Miramer (registered trademark) M340 (manufactured by MIWON) 21.3 parts by mass NK Ester (registered trademark) A-DCP (manufactured by SHIN-NAKAMURA CHEMICAL Co., Ltd.) 21.3 parts by mass
Banbeam (registered trademark) UV-22A (manufactured by Harima Chemicals, Inc.) 10.0 parts by mass
Resin prepared by copolymerizing 25% by mass of methyl methacrylate, 25% by mass of styrene, and 50% by mass of methacrylic acid and adding glycidylmethacrylate, in an amount of 0.6 equivalent relative to the carboxyl groups in the copolymer, to the copolymer though addition reaction 11.9 parts by mass
2,4,6-trimethylbenzoyl-diphenyl-phosphine oxide (Lucirin (registered trademark) TPO, manufactured by BASF) 4.0 parts by mass
2-[4-(methylthio)benzoyl]-2-(4-morpholinyl)propane (Irgacure (registered trademark) 907, manufactured by BASF) 2.0 parts by mass
2,4-diethyl-thioxanthen-9-one (Kayacure (registered trademark) DETX-S, manufactured by Nippon Kayaku Co., Ltd.) 3.0 parts by mass
p-methoxy phenol (manufactured by Wako Pure Chemical Corporation) 0.1 part by mass Disperbyk (registered trademark) 111 (manufactured by BYK Japan KK) 2.0 parts by mass
Lauryl acrylate (manufactured by Wako Pure Chemical Corporation) 4.0 parts by mass Pure water (manufactured by Wako Pure Chemical Corporation) 0.4 part by mass
KTL (registered trademark) 4N (manufactured by KITAMURA LIMITED) 1.0 parts by mass

### [Example 1]

A lithographic printing plate precursor was prepared by the procedure described below. An organic layer composition as described below was spared over an aluminum substrate (manufactured by Norsk Hydro ASA) having a thickness of 0.27 mm and dried at 210°C for 86 seconds in a safety oven (SPH-200, manufactured by ESPEC Corp.) to form an organic layer having a thickness of 7.4 µm. The organic layer composition was prepared by stirring and mixing the following components at room temperature.

### <Organic layer composition>

(a) Polymer having active hydrogen: epoxy resin: EPIKOTE (registered trademark) 1010 (manufactured by Japan Epoxy Resin Co., Ltd.): 30.4 parts by mass
(b) Polymer having active hydrogen: polyurethane: Sanprene (registered trademark) LQ-T1331D (manufactured by Sanyo Chemical Industries Ltd., solid content: 20% by mass): 57.3 parts by mass
(c) Aluminum chelate: aluminum chelate ALCH-TR (manufactured by Kawaken Fine Chemicals Co., Ltd.): 6.2 parts by mass
(d) Leveling agent: Disparlon (registered trademark) LC951 (manufactured by Kusumoto Chemicals Ltd., solid content: 10% by mass): 0.1 part by mass
(e) Titanium oxide: N,N-dimethyl formamide dispersion liquid of Tipaque (registered trademark) CR-50 (manufactured by Ishihara Sangyo Co., Ltd.) (titanium oxide 50% by mass): 6.0 parts by mass
(f) N,N-dimethyl formamide: 450 parts by mass
(g) Methyl ethyl ketone: 150 parts by mass

Here, the quantities of the above components of the organic layer composition are shown in parts by mass relative to the total quantity of the components (a) to (e), which accounts for 100 parts by mass.

Subsequently, the undermentioned heat-sensitive layer composition 1 was spread over the aforementioned organic layer and heated for drying at 140°C for 80 seconds to form a heat-sensitive layer with a thickness of 1.2 µm. Here, the heat-sensitive layer composition 1 was prepared by stirring and mixing the following components at room temperature.

### <Heat-sensitive layer composition 1>

(a) Meta para cresol novolac resin: LF-120 (manufactured by Lignyte Inc.): 51.4 parts by mass
(b) Polyurethane: Sanprene (registered trademark) LQ-T1333 (manufactured by Sanyo Chemical Industries Ltd.): 8.6 parts by mass
(c) Near-infrared absorbing dye: YKR2016 (λmax=750 to 850 nm, manufactured by Yamamoto Chemicals Inc.): 40.0 parts by mass
(d) Tetrahydrofuran: 614 parts by mass
(e) t-Butanol: 207 parts by mass
(f) N,N-dimethyl formamide: 18 parts by mass
(g) Ethanol: 61 parts by mass

Here, the quantities of the above components of the heat-sensitive layer composition are shown in parts by mass relative to the total quantity of the components (a) to (c), which accounts for 100 parts by mass.

Subsequently, the undermentioned ink repellent layer (silicone rubber layer) composition, which had been prepared immediately before application, was applied over the heat-sensitive layer and heated at 140°C for 70 seconds to form an ink repellent layer with an average thickness of 3.0 µm, thereby producing a lithographic printing plate precursor 1. Here, the ink repellent layer composition was prepared by stirring and mixing the following components at room temperature.

### <Ink repellent layer composition>

(a) α,ω-divinylpolydimethy siloxane: DMS-V35 (weight average molecular weight 49,500, manufactured by GELEST Inc.): 86.95 parts by mass
(b) Methyl hydrogen siloxane RD-1 (manufactured by Dow Toray Co., Ltd.): 4.24 parts by mass
(c) Vinyl tris(methyl ethyl ketoximino)silane: 2.64 parts by mass
(d) Platinum catalyst SRX212 (manufactured by Dow Toray Co., Ltd., platinum catalyst 6.0% by mass): 6.17 parts by mass
(e) Isopar E (manufactured by Exxon Mobile Corporation): 900 parts by mass Here, the total quantity of the components (a) to (d) of the ink repellent layer composition 1 accounts for 100 parts by mass.

The lithographic printing plate precursor 1 thus prepared was evaluated according to the aforementioned method and results showed that the rate of gas generation was 8.721 × 10⁵ g/m³. The crosslink density of the silicone rubber in the ink repellent layer of this precursor was evaluated according to the aforementioned method and results showed that the molar ratio of (II)/(I) was 0.00250. In addition, this precursor was exposed to light and developed according to the aforementioned method and good results were obtained, showing a 2% halftone dot resolution of 100%, a 1% halftone dot resolution of 9%, a solvent resistance rated as 3, and a peeling resistance of heat-sensitive layer rated as 4.

### [Example 2]

Except for using the undermentioned heat-sensitive layer composition 2 instead of the heat-sensitive layer composition 1, the same procedure as in Example 1 was carried out to produce a lithographic printing plate precursor 2.

### <Heat-sensitive layer composition 2>

(a) Meta para cresol novolac resin: LF-120 (manufactured by Lignyte Inc.): 47.1 parts by mass
(b) Polyurethane: Sanprene (registered trademark) LQ-T1333 (manufactured by Sanyo Chemical Industries Ltd.): 7.9 parts by mass
(c) Near-infrared absorbing dye: YKR2016 (manufactured by Yamamoto Chemicals Inc.): 45.0 parts by mass
(d) Tetrahydrofuran: 614 parts by mass
(e) t-Butanol: 207 parts by mass
(f) N,N-dimethyl formamide: 18 parts by mass
(g) Ethanol: 61 parts by mass

Here, the quantities of the above components of the heat-sensitive layer composition are shown in parts by mass relative to the total quantity of the components (a) to (c), which accounts for 100 parts by mass.

The lithographic printing plate precursor 2 thus prepared was evaluated according to the aforementioned method and results showed that the rate of gas generation was 9.460 × 10⁵ g/m³. This precursor was exposed to light and developed according to the aforementioned method and good results were obtained, showing a 2% halftone dot resolution of 100%, a 1% halftone dot resolution of 23%, a solvent resistance rated as 3, and a peeling resistance of heat-sensitive layer rated as 3.

### [Example 3]

Except for using the undermentioned heat-sensitive layer composition 3 instead of the heat-sensitive layer composition 1, the same procedure as in Example 1 was carried out to produce a lithographic printing plate precursor 3.

### <Heat-sensitive layer composition 3>

(a) Phenol formaldehyde novolac resin: Sumilite Resin (registered trademark) PR53195 (manufactured by Sumitomo Bakelite Co., Ltd.): 62.0 parts by mass
(b) Polyurethane: Sanprene (registered trademark) LQ-T1333 (manufactured by Sanyo Chemical Industries Ltd.): 10.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Tetrahydrofuran: 614 parts by mass
(f) t-Butanol: 207 parts by mass
(g) N,N-dimethyl formamide: 18 parts by mass
(h) Ethanol: 61 parts by mass

Here, the quantities of the above components of the heat-sensitive layer composition are shown in parts by mass relative to the total quantity of the components (a) to (d), which accounts for 100 parts by mass.

The lithographic printing plate precursor 3 thus prepared was evaluated according to the aforementioned method and results showed that the rate of gas generation was 6.504 × 10⁵ g/m³. This precursor was exposed to light and developed according to the aforementioned method and good results were obtained, showing a 2% halftone dot resolution of 76%, a 1% halftone dot resolution of 0%, a solvent resistance rated as 5, and a peeling resistance of heat-sensitive layer rated as 5. In addition, printing test of the resulting lithographic printing plate was performed according to the aforementioned method and results show that printing was completed without problems.

### [Example 4]

Except for using the undermentioned heat-sensitive layer composition 4 instead of the heat-sensitive layer composition 1, the same procedure as in Example 1 was carried out to produce a lithographic printing plate precursor 4.

### <Heat-sensitive layer composition 4>

(a) Meta para cresol novolac resin: LF-120 (manufactured by Lignyte Inc.): 66.9 parts by mass
(b) Polyurethane: Sanprene (registered trademark) LQ-T1333 (manufactured by Sanyo Chemical Industries Ltd.): 11.1 parts by mass
(c) Near-infrared absorbing dye: YKR2016 (manufactured by Yamamoto Chemicals Inc.): 15.0 parts by mass
(d) Easily heat-decomposable compound: fluorescein (λmax = 450 to 550 nm, heat decomposition temperature: 320°C, fluoresceins) (manufactured by Wako Pure Chemical Corporation): 7.0 parts by mass
(e) Tetrahydrofuran: 614 parts by mass
(f) t-Butanol: 207 parts by mass
(g) N,N-dimethyl formamide: 18 parts by mass
(h) Ethanol: 61 parts by mass

Here, the quantities of the above components of the heat-sensitive layer composition are shown in parts by mass relative to the total quantity of the components (a) to (d), which accounts for 100 parts by mass.

The lithographic printing plate precursor 4 thus prepared was evaluated according to the aforementioned method and results showed that the rate of gas generation was 6.947 × 10⁵ g/m³. This precursor was exposed to light and developed according to the aforementioned method and good results were obtained, showing a 2% halftone dot resolution of 84%, a 1% halftone dot resolution of 0%, a solvent resistance rated as 3, and a peeling resistance of heat-sensitive layer rated as 5.

### [Example 5]

Except for using the undermentioned heat-sensitive layer composition 5 instead of the heat-sensitive layer composition 1, the same procedure as in Example 1 was carried out to produce a lithographic printing plate precursor 5.

### <Heat-sensitive layer composition 5>

(a) Meta para cresol novolac resin: LF-120 (manufactured by Lignyte Inc.): 66.9 parts by mass
(b) Polyurethane: Sanprene (registered trademark) LQ-T1333 (manufactured by Sanyo Chemical Industries Ltd.): 11.1 parts by mass
(c) Near-infrared absorbing dye: YKR2016 (manufactured by Yamamoto Chemicals Inc.): 15.0 parts by mass
(d) Easily heat-decomposable compound: riboflavin (λmax = 200 to 300 nm, heat decomposition temperature: 282°C, vitamins) (manufactured by Wako Pure Chemical Corporation): 7.0 parts by mass
(e) Tetrahydrofuran: 614 parts by mass
(f) t-Butanol: 207 parts by mass
(g) N,N-dimethyl formamide: 18 parts by mass
(h) Ethanol: 61 parts by mass

Here, the quantities of the above components of the heat-sensitive layer composition are shown in parts by mass relative to the total quantity of the components (a) to (d), which accounts for 100 parts by mass.

The lithographic printing plate precursor 5 thus prepared was evaluated according to the aforementioned method and results showed that the rate of gas generation was 7.539 × 10⁵ g/m³. This precursor was exposed to light and developed according to the aforementioned method and good results were obtained, showing a 2% halftone dot resolution of 95%, a 1% halftone dot resolution of 0%, a solvent resistance rated as 3, and a peeling resistance of heat-sensitive layer rated as 5.

### [Example 6]

Except for using the undermentioned heat-sensitive layer composition 6 instead of the heat-sensitive layer composition 1, the same procedure as in Example 1 was carried out to produce a lithographic printing plate precursor 6.

### <Heat-sensitive layer composition 6>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: methyl red (λmax = 400 to 600 nm, heat decomposition temperature: 210°C, azo based dye) (manufactured by Wako Pure Chemical Corporation): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 6 thus prepared was evaluated according to the aforementioned method and results showed that the rate of gas generation was 6.800 × 10⁵ g/m³. This precursor was exposed to light and developed according to the aforementioned method and good results were obtained, showing a 2% halftone dot resolution of 81%, a 1% halftone dot resolution of 0%, a solvent resistance rated as 5, and a peeling resistance of heat-sensitive layer rated as 5.

### [Example 7]

Except for using the undermentioned heat-sensitive layer composition 7 instead of the heat-sensitive layer composition 1, the same procedure as in Example 1 was carried out to produce a lithographic printing plate precursor 7.

### <Heat-sensitive layer composition 7>

(a) Phenol formaldehyde novolac resin: Sumilite Resin (registered trademark) PR53195 (manufactured by Sumitomo Bakelite Co., Ltd.): 61.9 parts by mass
(b) Polyurethane: Sanprene (registered trademark) LQ-T1333 (manufactured by Sanyo Chemical Industries Ltd.): 10.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: congo red (λmax = 450 to 550 nm, heat decomposition temperature: 360°C, azo based dye) (manufactured by Wako Pure Chemical Corporation): 0.1 part by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 7 thus prepared was evaluated according to the aforementioned method and results showed that the rate of gas generation was 6.947 × 10⁵ g/m³. This precursor was exposed to light and developed according to the aforementioned method and good results were obtained, showing a 2% halftone dot resolution of 84%, a 1% halftone dot resolution of 0%, a solvent resistance rated as 5, and a peeling resistance of heat-sensitive layer rated as 5.

### [Example 8]

Except for using the undermentioned heat-sensitive layer composition 8 instead of the heat-sensitive layer composition 1, the same procedure as in Example 1 was carried out to produce a lithographic printing plate precursor 8.

### <Heat-sensitive layer composition 8>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: congo red (λmax = 450 to 550 nm, heat decomposition temperature: 360°C, azo based dye) (manufactured by Wako Pure Chemical Corporation): 7.0 part by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 8 thus prepared was evaluated according to the aforementioned method and results showed that the rate of gas generation was 8.721 × 10⁵ g/m³. This precursor was exposed to light and developed according to the aforementioned method and good results were obtained, showing a 2% halftone dot resolution of 100%, a 1% halftone dot resolution of 9%, a solvent resistance rated as 5, and a peeling resistance of heat-sensitive layer rated as 5.

### [Example 9]

Except for using the undermentioned heat-sensitive layer composition 9 instead of the heat-sensitive layer composition 1, the same procedure as in Example 1 was carried out to produce a lithographic printing plate precursor 9.

### <Heat-sensitive layer composition 9>

(a) Phenol formaldehyde novolac resin: Sumilite Resin (registered trademark) PR53195 (manufactured by Sumitomo Bakelite Co., Ltd.): 44.8 parts by mass
(b) Polyurethane: Sanprene (registered trademark) LQ-T1333 (manufactured by Sanyo Chemical Industries Ltd.): 7.5 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: congo red (λmax = 450 to 550 nm, heat decomposition temperature: 360°C, azo based dye) (manufactured by Wako Pure Chemical Corporation): 20.0 part by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 9 thus prepared was evaluated according to the aforementioned method and results showed that the rate of gas generation was 10.643 × 10⁵ g/m³. This precursor was exposed to light and developed according to the aforementioned method and good results were obtained, showing a 2% halftone dot resolution of 100%, a 1% halftone dot resolution of 44%, a solvent resistance rated as 4, and a peeling resistance of heat-sensitive layer rated as 5.

### [Example 10]

Except for using the undermentioned heat-sensitive layer composition 10 instead of the heat-sensitive layer composition 1, the same procedure as in Example 1 was carried out to produce a lithographic printing plate precursor 10.

### <Heat-sensitive layer composition 10>

(a) Phenol formaldehyde novolac resin: Sumilite Resin (registered trademark) PR53195 (manufactured by Sumitomo Bakelite Co., Ltd.): 27.7 parts by mass
(b) Polyurethane: Sanprene (registered trademark) LQ-T1333 (manufactured by Sanyo Chemical Industries Ltd.): 4.6 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: congo red (λmax = 450 to 550 nm, heat decomposition temperature: 360°C, azo based dye) (manufactured by Wako Pure Chemical Corporation): 40.0 part by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 10 thus prepared was evaluated according to the aforementioned method and results showed that the rate of gas generation was 11.678 × 10⁵ g/m³. This precursor was exposed to light and developed according to the aforementioned method and good results were obtained, showing a 2% halftone dot resolution of 100%, a 1% halftone dot resolution of 63%, a solvent resistance rated as 4, and a peeling resistance of heat-sensitive layer rated as 5.

### [Example 11]

Except for using the undermentioned heat-sensitive layer composition 11 instead of the heat-sensitive layer composition 1, the same procedure as in Example 1 was carried out to produce a lithographic printing plate precursor 11.

### <Heat-sensitive layer composition 11>

(a) Phenol formaldehyde novolac resin: Sumilite Resin (registered trademark) PR53195 (manufactured by Sumitomo Bakelite Co., Ltd.): 23.4 parts by mass
(b) Polyurethane: Sanprene (registered trademark) LQ-T1333 (manufactured by Sanyo Chemical Industries Ltd.): 3.9 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: congo red (λmax = 450 to 550 nm, heat decomposition temperature: 360°C, azo based dye) (manufactured by Wako Pure Chemical Corporation): 45.0 part by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 11 thus prepared was evaluated according to the aforementioned method and results showed that the rate of gas generation was 12.417 × 10⁵ g/m³. This precursor was exposed to light and developed according to the aforementioned method and good results were obtained, showing a 2% halftone dot resolution of 100%, a 1% halftone dot resolution of 76%, a solvent resistance rated as 3, and a peeling resistance of heat-sensitive layer rated as 5.

### [Example 12]

Except for using the undermentioned heat-sensitive layer composition 12 instead of the heat-sensitive layer composition 1, the same procedure as in Example 1 was carried out to produce a lithographic printing plate precursor 12.

### <Heat-sensitive layer composition 12>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: fluorescein (λmax = 450 to 550 nm, heat decomposition temperature: 320°C, fluoresceins) (manufactured by Wako Pure Chemical Corporation): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 12 thus prepared was evaluated according to the aforementioned method and results showed that the rate of gas generation was 9.608 × 10⁵ g/m³. This precursor was exposed to light and developed according to the aforementioned method and good results were obtained, showing a 2% halftone dot resolution of 100%, a 1% halftone dot resolution of 25%, a solvent resistance rated as 5, and a peeling resistance of heat-sensitive layer rated as 5.

### [Example 13]

Except for using the undermentioned heat-sensitive layer composition 13 instead of the heat-sensitive layer composition 1, the same procedure as in Example 1 was carried out to produce a lithographic printing plate precursor 13.

### <Heat-sensitive layer composition 13>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: riboflavin (λmax = 200 to 300 nm, heat decomposition temperature: 282°C, vitamins) (manufactured by Wako Pure Chemical Corporation): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 13 thus prepared was evaluated according to the aforementioned method and results showed that the rate of gas generation was 10.199 × 10⁵ g/m³. This precursor was exposed to light and developed according to the aforementioned method and good results were obtained, showing a 2% halftone dot resolution of 100%, a 1% halftone dot resolution of 36%, a solvent resistance rated as 5, and a peeling resistance of heat-sensitive layer rated as 5.

### [Example 14]

Except for using the undermentioned heat-sensitive layer composition 14 instead of the heat-sensitive layer composition 1, the same procedure as in Example 1 was carried out to produce a lithographic printing plate precursor 14.

### <Heat-sensitive layer composition 14>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: bromocresol purple (λmax = 400 to 600 nm, heat decomposition temperature: 240°C, triphenyl methane based dye) (manufactured by Tokyo Chemical Industry Co., Ltd.): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 14 thus prepared was evaluated according to the aforementioned method and results showed that the rate of gas generation was 10.791 × 10⁵ g/m³. This precursor was exposed to light and developed according to the aforementioned method and good results were obtained, showing a 2% halftone dot resolution of 100%, a 1% halftone dot resolution of 47%, a solvent resistance rated as 5, and a peeling resistance of heat-sensitive layer rated as 5.

### [Example 15]

Except for using the undermentioned heat-sensitive layer composition 15 instead of the heat-sensitive layer composition 1, the same procedure as in Example 1 was carried out to produce a lithographic printing plate precursor 15.

### <Heat-sensitive layer composition 15>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: bromocresol green sodium salt (λmax = 400 to 650 nm, heat decomposition temperature: 230°C, triphenyl methane based dye) (manufactured by Tokyo Chemical Industry Co., Ltd.): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 15 thus prepared was evaluated according to the aforementioned method and results showed that the rate of gas generation was 10.938 × 10⁵ g/m³. This precursor was exposed to light and developed according to the aforementioned method and good results were obtained, showing a 2% halftone dot resolution of 100%, a 1% halftone dot resolution of 49%, a solvent resistance rated as 5, and a peeling resistance of heat-sensitive layer rated as 5.

### [Example 16]

Except for using the undermentioned heat-sensitive layer composition 16 instead of the heat-sensitive layer composition 1, the same procedure as in Example 1 was carried out to produce a lithographic printing plate precursor 16.

### <Heat-sensitive layer composition 16>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: thymol blue (λmax = 350 to 600 nm, heat decomposition temperature: 220°C, triphenyl methane based dye) (manufactured by Wako Pure Chemical Corporation): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 16 thus prepared was evaluated according to the aforementioned method and results showed that the rate of gas generation was 11.086 × 10⁵ g/m³. This precursor was exposed to light and developed according to the aforementioned method and good results were obtained, showing a 2% halftone dot resolution of 100%, a 1% halftone dot resolution of 52%, a solvent resistance rated as 5, and a peeling resistance of heat-sensitive layer rated as 5.

### [Example 17]

Except for using the undermentioned heat-sensitive layer composition 17 instead of the heat-sensitive layer composition 1, the same procedure as in Example 1 was carried out to produce a lithographic printing plate precursor 17.

### <Heat-sensitive layer composition 17>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: bromocresol green (λmax = 400 to 650 nm, heat decomposition temperature: 218°C, triphenyl methane based dye) (manufactured by Sigma-Aldrich Japan): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 17 thus prepared was evaluated according to the aforementioned method and results showed that the rate of gas generation was 11.136 × 10⁵ g/m³. This precursor was exposed to light and developed according to the aforementioned method and good results were obtained, showing a 2% halftone dot resolution of 100%, a 1% halftone dot resolution of 53%, a solvent resistance rated as 5, and a peeling resistance of heat-sensitive layer rated as 5.

### [Example 18]

Except for using the undermentioned heat-sensitive layer composition 18 instead of the heat-sensitive layer composition 1, the same procedure as in Example 1 was carried out to produce a lithographic printing plate precursor 18.

### <Heat-sensitive layer composition 18>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: bromothymol blue sodium salt (λmax = 350 to 650 nm, heat decomposition temperature: 205°C, triphenyl methane based dye) (manufactured by Tokyo Chemical Industry Co., Ltd.): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 18 thus prepared was evaluated according to the aforementioned method and results showed that the rate of gas generation was 11.456 × 10⁵ g/m³. This precursor was exposed to light and developed according to the aforementioned method and good results were obtained, showing a 2% halftone dot resolution of 100%, a 1% halftone dot resolution of 59%, a solvent resistance rated as 5, and a peeling resistance of heat-sensitive layer rated as 5.

### [Example 19]

Except for using the undermentioned heat-sensitive layer composition 19 instead of the heat-sensitive layer composition 1, the same procedure as in Example 1 was carried out to produce a lithographic printing plate precursor 19.

### <Heat-sensitive layer composition 19>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: tetrabromophenol blue (λmax = 350 to 650 nm, heat decomposition temperature: 204°C, triphenyl methane based dye) (manufactured by Wako Pure Chemical Corporation): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 19 thus prepared was evaluated according to the aforementioned method and results showed that the rate of gas generation was 11.480 × 10⁵ g/m³. This precursor was exposed to light and developed according to the aforementioned method and good results were obtained, showing a 2% halftone dot resolution of 100%, a 1% halftone dot resolution of 59%, a solvent resistance rated as 5, and a peeling resistance of heat-sensitive layer rated as 5.

### [Example 20]

Except for using the undermentioned heat-sensitive layer composition 20 instead of the heat-sensitive layer composition 1, the same procedure as in Example 1 was carried out to produce a lithographic printing plate precursor 20.

### <Heat-sensitive layer composition 20>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: bromothymol blue (λmax = 400 to 650 nm, heat decomposition temperature: 202°C, triphenyl methane based dye) (manufactured by Wako Pure Chemical Corporation): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 20 thus prepared was evaluated according to the aforementioned method and results showed that the rate of gas generation was 11.530 × 10⁵ g/m³. This precursor was exposed to light and developed according to the aforementioned method and very good results were obtained, showing a 2% halftone dot resolution of 100%, a 1% halftone dot resolution of 60%, a solvent resistance rated as 5, and a peeling resistance of heat-sensitive layer rated as 5. In addition, printing test of the resulting lithographic printing plate was performed according to the aforementioned method and results show that printing was completed without problems.

### [Example 21]

Except for using the undermentioned heat-sensitive layer composition 21 instead of the heat-sensitive layer composition 1, the same procedure as in Example 1 was carried out to produce a lithographic printing plate precursor 21.

### <Heat-sensitive layer composition 21 >

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: basic fuchsin (λmax = 450 to 600 nm, heat decomposition temperature: 200°C, triphenyl methane based dye) (manufactured by Wako Pure Chemical Corporation): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 21 thus prepared was evaluated according to the aforementioned method and results showed that the rate of gas generation was 11.678 × 10⁵ g/m³. This precursor was exposed to light and developed according to the aforementioned method and very good results were obtained, showing a 2% halftone dot resolution of 100%, a 1% halftone dot resolution of 63%, a solvent resistance rated as 5, and a peeling resistance of heat-sensitive layer rated as 5.

### [Example 22]

Except for using the undermentioned heat-sensitive layer composition 22 instead of the heat-sensitive layer composition 1, the same procedure as in Example 1 was carried out to produce a lithographic printing plate precursor 22.

### <Heat-sensitive layer composition 22>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: (L+)-ascorbic acid (λmax = <300 nm, heat decomposition temperature: 190°C, vitamins) (manufactured by Wako Pure Chemical Corporation): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 22 thus prepared was evaluated according to the aforementioned method and results showed that the rate of gas generation was 11.973 × 10⁵ g/m³. This precursor was exposed to light and developed according to the aforementioned method and very good results were obtained, showing a 2% halftone dot resolution of 100%, a 1% halftone dot resolution of 68%, a solvent resistance rated as 5, and a peeling resistance of heat-sensitive layer rated as 5. In addition, printing test of the resulting lithographic printing plate was performed according to the aforementioned method and results show that printing was completed without problems.

### [Example 23]

Except for using the undermentioned heat-sensitive layer composition 23 instead of the heat-sensitive layer composition 1, the same procedure as in Example 1 was carried out to produce a lithographic printing plate precursor 23.

### <Heat-sensitive layer composition 23>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass

(e) Easily heat-decomposable compound: malachite green oxalate (λmax = 550 to 650 nm, heat decomposition temperature: 164°C, triphenyl methane based dye) (manufactured by Tokyo Chemical Industry Co., Ltd.): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 23 thus prepared was evaluated according to the aforementioned method and results showed that the rate of gas generation was 12.195 × 10⁵ g/m³. This precursor was exposed to light and developed according to the aforementioned method and very good results were obtained, showing a 2% halftone dot resolution of 100%, a 1% halftone dot resolution of 72%, a solvent resistance rated as 5, and a peeling resistance of heat-sensitive layer rated as 5.

### [Example 24]

Except for using the undermentioned heat-sensitive layer composition 24 instead of the heat-sensitive layer composition 1, the same procedure as in Example 1 was carried out to produce a lithographic printing plate precursor 24.

### <Heat-sensitive layer composition 24>

(a) Phenol formaldehyde novolac resin: Sumilite Resin (registered trademark) PR53195 (manufactured by Sumitomo Bakelite Co., Ltd.): 56.0 parts by mass
(b) Polyurethane: Sanprene (registered trademark) LQ-T1333 (manufactured by Sanyo Chemical Industries Ltd.): 9.3 parts by mass
(c) Near-infrared absorbing dye: YKR2016 (manufactured by Yamamoto Chemicals Inc.): 15.0 parts by mass
(d) Titanium chelate: Na̅cem (registered trademark) Titanium (manufactured by Nihon Kagaku Sangyo Co., Ltd.): 12.7 parts by mass
(e) Easily heat-decomposable compound: methyl yellow (λmax = 250 to 550 nm, heat decomposition temperature: 111°C, azo based dye) (manufactured by Tokyo Chemical Industry Co., Ltd.): 7.0 parts by mass
(f) Tetrahydrofuran: 614 parts by mass
(g) t-Butanol: 207 parts by mass
(h) N,N-dimethyl formamide: 18 parts by mass
(i) Ethanol: 61 parts by mass

Here, the quantities of the above components of the heat-sensitive layer composition are shown in parts by mass relative to the total quantity of the components (a) to (e), which accounts for 100 parts by mass.

The lithographic printing plate precursor 24 thus prepared was evaluated according to the aforementioned method and results showed that the rate of gas generation was 8.573 × 10⁵ g/m³. This precursor was exposed to light and developed according to the aforementioned method and good results were obtained, showing a 2% halftone dot resolution of 100%, a 1% halftone dot resolution of 7%, a solvent resistance rated as 3, and a peeling resistance of heat-sensitive layer rated as 5.

### [Comparative example 1]

Except for using the undermentioned heat-sensitive layer composition 25 instead of the heat-sensitive layer composition 1, the same procedure as in Example 1 was carried out to produce a lithographic printing plate precursor 25.

### <Heat-sensitive layer composition 25>

(a) Phenol formaldehyde novolac resin: Sumilite Resin (registered trademark) PR53195 (manufactured by Sumitomo Bakelite Co., Ltd.): 100 parts by mass
(b) Tetrahydrofuran: 675 parts by mass
(c) t-Butanol: 207 parts by mass
(d) N,N-dimethyl formamide: 18 parts by mass

Here, the quantities of the above components of the heat-sensitive layer composition are shown in parts by mass relative to the quantity of the component (a), which accounts for 100 parts by mass.

The lithographic printing plate precursor 25 thus prepared was evaluated according to the aforementioned method and results showed that the rate of gas generation was 0.667 × 10⁵ g/m³. This precursor was exposed to light and developed according to the aforementioned method and results showed a 2% halftone dot resolution of 0% and a 1% halftone dot resolution of 0%. Since the rate of gas generation was small, it is considered that the heat-sensitive layer did not undergo a sufficient degree of structure destruction. In addition, the solvent resistance was rated as 1, and the peeling resistance of heat-sensitive layer was rated as 5, showing that the precursor was unacceptable for practical use in terms of resolution and solvent resistance.

### [Comparative example 2]

Except for using the undermentioned heat-sensitive layer composition 26 instead of the heat-sensitive layer composition 1, the same procedure as in Example 1 was carried out to produce a lithographic printing plate precursor 26.

### <Heat-sensitive layer composition 26>

(a) Resol resin: Sumilite Resin (registered trademark) PR-51904 (manufactured by Sumitomo Bakelite Co., Ltd.): 100 parts by mass
(b) Tetrahydrofuran: 675 parts by mass
(c) t-Butanol: 207 parts by mass
(d) N,N-dimethyl formamide: 18 parts by mass

Here, the quantities of the above components of the heat-sensitive layer composition are shown in parts by mass relative to the quantity of the component (a), which accounts for 100 parts by mass.

The lithographic printing plate precursor 26 thus prepared was evaluated according to the aforementioned method and results showed that the rate of gas generation was 0.583 × 10⁵ g/m³. This precursor was exposed to light and developed according to the aforementioned method and results showed a 2% halftone dot resolution of 0% and a 1% halftone dot resolution of 0%. Since the rate of gas generation was small, it is considered that the heat-sensitive layer did not undergo a sufficient degree of structure destruction. In addition, the solvent resistance was rated as 5 and the peeling resistance of heat-sensitive layer was rated as 5, showing that the precursor was unacceptable for practical use in terms of resolution.

### [Comparative example 3]

Except for using the undermentioned heat-sensitive layer composition 27 instead of the heat-sensitive layer composition 1, the same procedure as in Example 1 was carried out to produce a lithographic printing plate precursor 27.

### <Heat-sensitive layer composition 27>

(a) Acrylic resin: poly(methylmethacrylate) (manufactured by Tokyo Chemical Industry Co., Ltd.): 100 parts by mass
(b) Tetrahydrofuran: 675 parts by mass
(c) t-Butanol: 207 parts by mass
(d) N,N-dimethyl formamide: 18 parts by mass

Here, the quantities of the above components of the heat-sensitive layer composition are shown in parts by mass relative to the quantity of the component (a), which accounts for 100 parts by mass.

The lithographic printing plate precursor 27 thus prepared was evaluat0ed according to the aforementioned method and results showed that the rate of gas generation was 13.043 x 10⁵ g/m³. This precursor was exposed to light and developed according to the aforementioned method and results showed a 2% halftone dot resolution of 1000% and a 1% halftone dot resolution of 87%. In addition, the solvent resistance was rated as 1 and the peeling resistance of heat-sensitive layer was rated as 1. Since the rate of gas generation was very large, it is considered that the heat-sensitive layer underwent an excessive degree of structure destruction. Results show that the precursor was unacceptable for practical use in terms of solvent resistance and peeling resistance of heat-sensitive layer.

### [Comparative example 4]

Except for using the undermentioned heat-sensitive layer composition 28 instead of the heat-sensitive layer composition 1 and heating and drying it at 150°C for 80 seconds to form a heat-sensitive layer with a thickness of 2.0 µm, the same procedure as in Example 1 was carried out to produce a lithographic printing plate precursor 28.

### <Heat-sensitive layer composition 28>

(a) Phenol formaldehyde novolac resin: Sumilite Resin (registered trademark) PR54652 (manufactured by Sumitomo Bakelite Co., Ltd.): 62.7 parts by mass
(b) Polyurethane: Sanprene (registered trademark) LQ-T1333 (manufactured by Sanyo Chemical Industries Ltd.): 10.4 parts by mass
(c) Near-infrared absorbing dye: PROJET 825LDI (manufactured by Avecia): 10.4 parts by mass
(d) Titanium chelate: Na̅cem (registered trademark) Titanium (manufactured by Nihon Kagaku Sangyo Co., Ltd.): 16.5 parts by mass
(f) Tetrahydrofuran: 631 parts by mass
(g) Ethanol: 38 parts by mass

Here, the quantities of the above components of the heat-sensitive layer composition are shown in parts by mass relative to the total quantity of the components (a) to (d), which accounts for 100 parts by mass.

The lithographic printing plate precursor 28 thus prepared was evaluated according to the aforementioned method and results showed that the rate of gas generation was 6.061 × 10⁵ g/m³. This precursor was exposed to light and developed according to the aforementioned method and results showed a 2% halftone dot resolution of 66% and a 1% halftone dot resolution of 0%. Since the rate of gas generation was small, it is considered that the heat-sensitive layer did not undergo a sufficient degree of structure destruction. In addition, the solvent resistance was rated as 5 and the peeling resistance of heat-sensitive layer was rated as 5, showing that the precursor was unacceptable for practical use in terms of resolution.

The above evaluation results are summarized in Tables 1 and 2.

**[Table 1]**

| | | Heat-sensitive layer composition | | | | | | |
|---|---|---|---|---|---|---|---|---|
| | | near-infrared absorbing compound | | type of metal chelate | easily heat-decomposable compound | | | |
| | | type | content (parts by mass) | | type | melting before heat decomposition | content (parts by mass) | heat decomposition temperature |
| | (1) | YKR-2016 | 40.0 | - | - | - | - | - |
| | (2) | YKR-2016 | 45.0 | - | - | - | - | - |
| | (3) | YKR-2016 | 15.0 | titanium chelate | - | - | - | - |
| | (4) | YKR-2016 | 15.0 | - | fluorescein | no | 7.0 | 320°C |
| | (5) | YKR-2016 | 15.0 | - | riboflavin | no | 7.0 | 282°C |
| | (6) | YKR-2016 | YKR-2016 15.0 | titanium chelate | methyl red | yes | 7.0 | 210°C |
| | (7) | YKR-2016 | 15.0 | titanium chelate | congo red | no | 0.1 | 360°C |
| | (8) | YKR-2016 | 15.0 | titanium chelate | congo red | no | 7.0 | 360°C |
| | (9) | YKR-2016 | YKR-2016 15.0 | titanium chelate | congo red | no | 20.0 | 360°C |
| | (10) | YKR-2016 | 15.0 | titanium chelate | congo red | no | 40.0 | 360°C |
| | (11) | YKR-2016 | 15.0 | titanium chelate | congo red | no | 45.0 | 360°C |
| | (12) | YKR-2016 | 15.0 | titanium chelate | fluorescein | no | 7.0 | 320°C |
| Example | (13) | YKR-2016 | 15.0 | titanium chelate | riboflavin | no | 7.0 | 282°C |
| | (14) | | 15.0 YKR-2016 15.0 | titanium chelate | bromocresol purple | no | 7.0 | 240°C |
| | (15) | YKR-2016 | 15.0 | titanium chelate | bromocresol green sodium salt | no | 7.0 | 230°C |
| | (16) | YKR-2016 | 15.0 | titanium chelate | thymol blue | no | 7.0 | 220°C |
| | (17) | | YKR-2016 15.0 | titanium chelate | bromocresol green | no | 7.0 | 218°C |
| | (18) | YKR-2016 | 15.0 | titanium chelate | bromothymol blue sodium salt | no | 7.0 | 205°C |
| | (19) | YKR-2016 | 15.0 | titanium chelate | tetrabromophenol blue | no | 7.0 | 204°C |
| | (20) | YKR-2016 | 15.0 | titanium chelate | bromothymol blue | no | 7.0 | 202°C |
| | (21) | YKR-2016 | 15.0 | titanium chelate | basic fuchsin | no | 7.0 | 200°C |
| | (22) | YKR-2016 | 15.0 | titanium chelate | (L+)-ascorbic acid | no | 7.0 | 190°C |
| | (23) | YKR-2016 | 15.0 | titanium chelate | malachite green oxalate | no | 7.0 | 164°C |
| | (24) | YKR-2016 | YKR-2016 15.0 | titanium chelate | methyl yellow | no | 7.0 | 111°C |
| Comparative example | (1) | - | - | - | - | - | - | - |
| | (2) | - | - | - | | | | |
| | (3) | - | - | - | - | - | - | - |
| | (4) | PROJET 825LDI | 10.4 | titanium chelate | - | - | - | - |

**[Table 2]**

| | | Rate of gas generation (× 10⁵ g/m³) | 2% half tone dot resolution (%) | 1% half tone dot resolution (%) | Solvent resistance | Peeling resistance of heat-sensitive layer |
|---|---|---|---|---|---|---|
| | (1) | 8.721 | 100 | 9 | 3 | 4 |
| | (2) | 9.460 | 100 | 23 | 3 | 3 |
| | (3) | 6.504 | 76 | 0 | 5 | 5 |
| | (4) | 6.947 | 84 | 0 | 3 | 5 |
| | (5) | 7.539 | 95 | 0 | 3 | 5 |
| | (6) | 6.800 | 81 | 0 | 5 | 5 |
| | (7) | 6.947 | 84 | 0 | 5 | 5 |
| | (8) | 8.721 | 100 | 9 | 5 | 5 |
| | (9) | 10.643 | 100 | 44 | 4 | 5 |
| | (10) | 11.678 | 100 | 63 | 4 | 5 |
| | (11) | 12.417 | 100 | 76 | 3 | 5 |
| Example | (12) | 9.608 | 100 | 25 | 5 | 5 |
| | (13) | 10.199 | 100 | 36 | 5 | 5 |
| | (14) | 10.791 | 100 | 47 | 5 | 5 |
| | (15) | 10.938 | 100 | 49 | 5 | 5 |
| | (16) | 11.086 | 100 | 52 | 5 | 5 |
| | (17) | 11.136 | 100 | 53 | 5 | 5 |
| | (18) | 11.456 | 100 | 59 | 5 | 5 |
| | (19) | 11.480 | 100 | 59 | 5 | 5 |
| | (20) | 11.530 | 100 | 60 | 5 | 5 |
| | (21) | 11.678 | 100 | 63 | 5 | 5 |
| | (22) | 11.973 | 100 | 68 | 5 | 5 |
| | (23) | 12.195 | 100 | 72 | 5 | 5 |
| | (24) | 8.573 | 100 | 7 | 3 | 5 |
| Comparative example | (1) | 0.667 | 0 | 0 | 1 | 5 |
| | (2) | 0.583 | 0 | 0 | 5 | 5 |
| | (3) | 13.043 | 100 | 87 | 1 | 1 |
| | (4) | 6.061 | 66 | 0 | 5 | 5 |

## Claims

1. A lithographic printing plate precursor comprising at least a heat-sensitive layer and an ink repellent layer disposed on a substrate, the rate of gas generation from 1 m³ of the heat-sensitive layer being 6.5 × 10⁵ g/m³ to 12.5 × 10⁵ g/m³ as determined by GC-MS analysis in which the lithographic printing plate precursor is heated in a nitrogen stream at 450°C for 5 minutes.

2. A lithographic printing plate precursor as set forth in claim 1, wherein the heat-sensitive layer contains a near-infrared absorbing compound having a maximum absorption wavelength in the wavelength range of 700 to 1,200 nm.

3. A lithographic printing plate precursor as set forth in claim 2, wherein the near-infrared absorbing compound accounts for 30% by mass or less of the heat-sensitive layer.

4. A lithographic printing plate precursor as set forth in claims 1 to_3, wherein the heat-sensitive layer contains an easily heat-decomposable compound being heat-decomposable at 450°C or less and not having a maximum absorption wavelength in the wavelength range of 700 to 1,200 nm.

5. A lithographic printing plate precursor as set forth in claim 4, wherein the easily heat-decomposable compound has a nature of being directly heat-decomposed without going through a melting stage.

6. A lithographic printing plate precursor as set forth in either claim 4 or 5, wherein the easily heat-decomposable compound accounts for 0.1% by mass to 40.0% by mass of the heat-sensitive layer.

7. A lithographic printing plate precursor as set forth in any one of claims 4 to 6, wherein the easily heat-decomposable compound has a heat decomposition temperature of 140°C to 350°C.

8. A lithographic printing plate precursor as set forth in any one of claims 4 to 7, wherein the easily heat-decomposable compound is at least one selected from the group consisting of triphenyl methane based dyes, thiazine based dyes, azo based dyes, xanthene based dyes, and vitamins.

9. A lithographic printing plate precursor as set forth in any one of claims 1 to 8, wherein the ink repellent layer is a silicone rubber layer comprising a silicone rubber having a structure derived from (a) an SiH group-containing compound and (b) a vinyl group-containing polysiloxane,
preferably wherein the silicone rubber contains a dimethyl siloxane unit as represented by the undermentioned general formula (I) and a siloxane unit as represented by the undermentioned general formula (II) and the peak area ratio represented as [(II) solid-state ²⁹Si NMR peak area attributed to Si** / (I) solid-state ²⁹Si NMR peak area attributed to Si*] is in the range of 0.00240 to 0.00900:
-Si*(CH₃)₂-O- (I)
-Si(CH₃)₂-CH₂-CH₂-Si**(CH₃)₂-O- (II)

10. A lithographic printing plate precursor as set forth in any one of claims 1 to 9, wherein the ink repellent layer contains an ink repellent liquid, the ink repellent liquid having a boiling point of 150°C or more at 1 atm,
preferably wherein the ink repellent liquid is a silicone oil.

11. A lithographic printing plate precursor as set forth in any one of claims 1 to 10, wherein the ink repellent layer has a thickness of 3 to 20 µm.

12. A method for producing a lithographic printing plate comprising either the step (1) or the step (2) described below for processing a lithographic printing plate precursor as set forth in any one of claims 1 to 11:
step (1) for performing light exposure according to an image (A), and
step (2) comprising the step (A) for performing light exposure and a subsequent step (B) for applying physical friction to the lithographic printing plate, which is previously light-exposed in the presence of water or an aqueous solution as developing liquid, in order to remove the ink repellent layer.

13. A method for producing printed matter comprising a step for adhering ink to the surface of a lithographic printing plate produced by the method for producing a lithographic printing plate set forth in claim 12 and a step for transferring the ink either directly or via a blanket to an object to be printed.

14. A method for producing printed matter as set forth in claim 13, wherein the object to be printed is a non-absorbent raw material.

15. A method for producing printed matter as set forth in claim 14, wherein the non-absorbent raw material is one selected from the group consisting of synthetic paper, cloth paper, plastic film, and metal.

## Patentansprüche

1. Eine Lithographiedruckplattenvorstufe, umfassend mindestens eine wärmeempfindliche Schicht und eine druckfarbenabweisende Schicht, die auf einem Substrat angeordnet sind, wobei die Rate der Gaserzeugung aus 1 m³ der wärmeempfindlichen Schicht, ermittelt durch GC-MS-Analyse, in der die Lithographiedruckplattenvorstufe in einem Stickstoffstrom bei 450°C für 5 Minuten erhitzt wird, 6,5 × 10⁵ g/m³ bis 12,5 × 10⁵ g/m³ beträgt.

2. Eine Lithographiedruckplattenvorstufe gemäß Anspruch 1, wobei die wärmeempfindliche Schicht eine im nahen Infrarot absorbierende Verbindung mit einer Absorptionsmaximumswellenlänge im Wellenlängenbereich von 700 bis 1.200 nm enthält.

3. Eine Lithographiedruckplattenvorstufe gemäß Anspruch 2, wobei die im nahen Infrarot absorbierende Verbindung 30 Massenprozent oder weniger der wärmeempfindlichen Schicht ausmacht.

4. Eine Lithographiedruckplattenvorstufe gemäß einem der Ansprüche 1 bis 3, wobei die wärmeempfindliche Schicht eine leicht wärmezersetzbare Verbindung enthält, die bei 450°C oder weniger wärmezersetzbar ist und keine Absorptionsmaximumswellenlänge im Wellenlängenbereich von 700 bis 1200 nm aufweist.

5. Eine Lithographiedruckplattenvorstufe gemäß Anspruch 4, wobei die leicht wärmezersetzbare Verbindung die Eigenschaft hat, direkt wärmezersetzt zu werden, ohne einen Schmelzvorgang zu durchlaufen.

6. Eine Lithographiedruckplattenvorstufe gemäß Anspruch 4 oder 5, wobei die leicht wärmezersetzbare Verbindung 0,1 Massenprozent bis 40,0 Massenprozent der wärmeempfindlichen Schicht ausmacht.

7. Eine Lithographiedruckplattenvorstufe gemäß einem der Ansprüche 4 bis 6, wobei die leicht wärmezersetzbare Verbindung eine Wärmezersetzungstemperatur von 140°C bis 350°C aufweist.

8. Eine Lithographiedruckplattenvorstufe gemäß einem der Ansprüche 4 bis 7, wobei die leicht wärmezersetzbare Verbindung mindestens eine Verbindung ist, die ausgewählt ist aus der Gruppe bestehend aus Farbstoffen auf Triphenylmethan-Basis, Farbstoffen auf Thiazin-Basis, Farbstoffen auf Azo-Basis, Farbstoffen auf Xanthen-Basis und Vitaminen.

9. Eine Lithographiedruckplattenvorstufe gemäß einem der Ansprüche 1 bis 8, wobei die druckfarbenabweisende Schicht eine Silikonkautschukschicht ist, die einen Silikonkautschuk mit einer Struktur umfasst, die abgeleitet ist von (a) einer SiH-Gruppen enthaltenden Verbindung und (b) einem Vinylgruppen enthaltenden Polysiloxan,
wobei der Silikonkautschuk vorzugsweise eine Dimethylsiloxaneinheit, wie sie durch die nachstehende allgemeine Formel (I) dargestellt ist, und eine Siloxaneinheit, wie sie durch die nachstehende allgemeine Formel (II) dargestellt ist, enthält und das Peakflächenverhältnis, dargestellt als [(II) Si** zugeordnete Festkörper-²⁹Si-NMR-Peakfläche / (I) Si* zugeordnete Festkörper-²⁹Si-NMR-Peakfläche], im Bereich von 0,00240 bis 0,00900 liegt:
-Si*(CH₃)₂-O- (I)
-Si(CH₃)₂-CH₂-CH₂-Si**(CH₃)₂-O- (II)

10. Eine Lithographiedruckplattenvorstufe gemäß einem der Ansprüche 1 bis 9, wobei die druckfarbenabweisende Schicht eine druckfarbenabweisende Flüssigkeit enthält, wobei die druckfarbenabweisende Flüssigkeit einen Siedepunkt von 150°C oder mehr bei 1 atm hat,
wobei die druckfarbenabweisende Flüssigkeit vorzugsweise ein Silikonöl ist.

11. Eine Lithographiedruckplattenvorstufe gemäß einem der Ansprüche 1 bis 10, wobei die druckfarbenabweisende Schicht eine Dicke von 3 bis 20 µm aufweist.

12. Ein Verfahren zur Herstellung einer Lithographiedruckplatte, umfassend entweder den unten beschriebenen Schritt (1) oder den unten beschriebenen Schritt (2) zur Verarbeitung einer Lithographiedruckplattenvorstufe gemäß einem der Ansprüche 1 bis 11:
Schritt (1) zur Durchführung der Belichtung gemäß einem Bild (A), und
Schritt (2) umfassend den Schritt (A) zur Durchführung der Belichtung und einen anschließenden Schritt (B) zur Anwendung physikalischer Reibung auf die Lithographiedruckplatte, die zuvor in Gegenwart von Wasser oder einer wässrigen Lösung als Entwicklungsflüssigkeit belichtet wurde, um die druckfarbenabweisende Schicht zu entfernen.

13. Ein Verfahren zur Herstellung von Druckerzeugnissen, umfassend einen Schritt zum Aufbringen von Druckfarbe auf die Oberfläche einer Lithographiedruckplatte, die durch das Verfahren zur Herstellung einer Lithographiedruckplatte gemäß Anspruch 12 hergestellt wurde, und einen Schritt zum Übertragen der Druckfarbe entweder direkt oder über ein Drucktuch auf ein zu bedruckendes Objekt.

14. Ein Verfahren zur Herstellung von Druckerzeugnissen gemäß Anspruch 13, wobei der zu bedruckende Gegenstand ein nicht absorbierendes Rohmaterial ist.

15. Ein Verfahren zur Herstellung von Druckerzeugnissen gemäß Anspruch 14, wobei das nicht absorbierende Rohmaterial eines ist, das aus der aus synthetischem Papier, Gewebepapier, Kunststofffolie und Metall bestehenden Gruppe ausgewählt wird.

## Revendications

1. Précurseur de plaque d'impression lithographique comprenant au moins une couche thermosensible et une couche de répulsif d'encre disposée sur un substrat, le taux de génération de gaz de 1 m³ de la couche thermosensible étant de 6,5 × 10⁵ g/m³ à 12,5 × 10⁵ g/m³ comme il est déterminé par une analyse GC-MS, dans laquelle le précurseur de plaque d'impression lithographique est chauffé dans un flux d'azote à 450 °C pendant 5 minutes.

2. Précurseur de plaque d'impression lithographique selon la revendication 1, dans lequel la couche thermosensible contient un composé d'absorption dans l'infrarouge proche présentant une longueur d'onde d'absorption maximum dans la plage de longueur d'onde de 700 à 1 200 nm.

3. Précurseur de plaque d'impression lithographique selon la revendication 2, dans lequel le composé d'absorption dans l'infrarouge proche compte pour 30 % en masse ou moins de la couche thermosensible.

4. Précurseur de plaque d'impression lithographique selon les revendications 1 à 3, dans lequel la couche thermosensible contient un composé facilement décomposable à la chaleur étant décomposable à la chaleur à 450 °C ou moins et ne présentant pas une longueur d'onde d'absorption maximum dans la plage de longueur d'onde de 700 à 1 200 nm.

5. Précurseur de plaque d'impression lithographique selon la revendication 4, dans lequel le composé facilement décomposable à la chaleur présente une nature d'état directement décomposé à la chaleur sans traverser une étape de fusion.

6. Précurseur de plaque d'impression lithographique selon la revendication 4 ou 5, dans lequel le composé facilement décomposable à la chaleur compte pour 0,1 % en masse à 40,0 % en masse de la couche thermosensible.

7. Précurseur de plaque d'impression lithographique selon l'une quelconque des revendications 4 à 6, dans lequel le composé facilement décomposable à la chaleur présente une température de décomposition à la chaleur de 140 °C à 350 °C.

8. Précurseur de plaque d'impression lithographique selon l'une quelconque des revendications 4 à 7, dans lequel le composé facilement décomposable à la chaleur est au moins un sélectionné à partir du groupe constitué de colorants à base de triphényl méthane, colorants à base de thiazine, colorants à base d'azo, colorants à base de xanthène, et vitamines.

9. Précurseur de plaque d'impression lithographique selon l'une quelconque des revendications 1 à 8, dans lequel la couche de répulsif d'encre est une couche de caoutchouc de silicone comprenant un caoutchouc de silicone présentant une structure dérivée de (a) un composé contenant un groupe de SiH et (b) un polysiloxane contenant un groupe de vinyle,
de préférence dans lequel le caoutchouc de silicone contient une unité de diméthyle siloxane comme elle est représentée par la formule générale mentionnée ci-dessous (I) et une unité de siloxane comme elle est représentée par la formule générale mentionnée ci-dessous (II) et le rapport de surface de pic représenté comme [(II) état solide ²⁹Si NMR surface de pic attribuée à Si** / (I) état solide ²⁹Si NMR surface de pic attribuée à Si^{∗}] est dans la plage de 0,00240 à 0,00900 :
-Si*(CH₃)₂-O- (I)
-Si(CH₃)₂-CH₂-CH₂-Si**(CH₃)₂-O- (II)

10. Précurseur de plaque d'impression lithographique selon l'une quelconque des revendications 1 à 9, dans lequel la couche de répulsif d'encre contient un liquide de répulsif d'encre, le liquide de répulsif d'encre présentant un point d'ébullition de 150 °C ou plus à 1 atm, de préférence dans lequel le liquide de répulsif d'encre est une huile de silicone.

11. Précurseur de plaque d'impression lithographique selon l'une quelconque des revendications 1 à 10, dans lequel la couche de répulsif d'encre présente une épaisseur de 3 à 20 µm.

12. Procédé de production d'une plaque d'impression lithographique comprenant l'étape (1) ou l'étape (2) décrites ci-dessous pour le traitement d'un précurseur de plaque d'impression lithographique selon l'une quelconque des revendications 1 à 11 :
étape (1) pour la réalisation de l'exposition à la lumière selon une image (A), et
l'étape (2) comprenant l'étape (A) pour la réalisation de l'exposition à la lumière et une étape ultérieure (B) pour l'application d'une friction physique à la plaque d'impression lithographique qui est précédemment exposée à la lumière en présence d'eau ou d'une solution aqueuse comme liquide de développement afin de retirer la couche de répulsif d'encre.

13. Procédé de production d'imprimés comprenant une étape pour l'adhérence de l'encre à la surface d'une plaque d'impression lithographique produite par le procédé de production d'une plaque d'impression lithographique selon la revendication 12 et une étape de transfert de l'encre directement ou via un blanchet à un objet à imprimer.

14. Procédé de production d'imprimés selon la revendication 13, dans lequel l'objet à imprimer est une matière première non absorbante.

15. Procédé de production d'imprimés selon la revendication 14, dans lequel la matière première non absorbante est une sélectionnée à partir du groupe constitué de papier synthétique, papier tissu, film plastique, et métal.
